# EUROPÄISCHE PATENTSCHRIFT

(11) **EP 2 689 445 B1**
(45) Veröffentlichungstag und Bekanntmachung des Hinweises auf die Patenterteilung: **30.08.2017**
(21) Anmeldenummer: 12715618.0
(22) Anmeldetag: 16.03.2012
(51) Int. Cl.: H01H 19/56, H01H 1/20, H01H 33/59, H01L 31/02, H01H 9/30, H01H 9/32, H01H 9/54, H01H 33/06

(54) **EIN- ODER MEHRPOLIGE SCHALTEINRICHTUNG, INSBESONDERE FÜR GLEICHSTROMANWENDUNGEN**
SINGLE- OR MULTI-POLE SWITCHING DEVICE, IN PARTICULAR FOR DC APPLICATIONS
SYSTÈME DE COMMUTATION UNIPOLAIRE OU MULTIPOLAIRE, DESTINÉ NOTAMMENT À DES APPLICATIONS DE COURANT CONTINU

(30) Priorität: 22.03.2011 DE 102011014696; 16.11.2011 DE 102011118713
(43) Veröffentlichungstag der Anmeldung: 29.01.2014
(73) Patentinhaber: Dehn + Söhne GmbH + Co. KG, 92318 Neumarkt/Opf. (DE)
(72) Erfinder: ZAHLMANN, Peter, 92318 Neumarkt (DE); SCHREITER, Stefanie, 92318 Neumarkt (DE); EHRHARDT, Arnd, 92318 Neumarkt (DE); ROCK, Michael, 07426 Königsee (DE)
(74) Vertreter: Kruspig, Volkmar
(86) Internationale Anmeldenummer: PCT/EP2012/054705
(87) Internationale Veröffentlichungsnummer: WO 2012/126850

(56) Entgegenhaltungen:
- EP-A1- 0 450 104
- EP-A1- 1 267 373
- DE-C- 640 498
- DE-C- 699 835
- DE-C- 699 835
- US-A- 2 732 463
- US-A- 5 126 517
- US-A1- 2009 179 011

## Beschreibung

Die Erfindung betrifft eine ein- oder mehrpolige Schalteinrichtung für Gleichstromanwendungen in Photovoltaikanlagen mit mindestens einem rotierenden Schaltelement, welches mit einem Antrieb in Verbindung steht, sowie umfassend Schaltkontakte, Anschlussstücke und Anschlusspole oder Anschlussklemmen und eine die vorgenannten Teile aufnehmende Gehäuseanordnung gemäß Oberbegriff des Patentanspruchs 1.

Schalter oder Schalteinrichtungen mit mehrfacher Unterbrechung sind beispielsweise aus der DE 594 755 A oder der EP 2 107 581 A1 vorbekannt.

Bei der Schalteinrichtung nach EP 2 107 581 A1 ist ein rotierendes Schaltelement vorhanden, das sich innerhalb einer Gehäuseanordnung befindet. Die Gehäuseanordnung nimmt darüber hinaus einen drehbeweglichen sowie einen stationären Kontakt bzw. entsprechende Kontaktpaare auf. Über einen Antrieb, der als Handknauf ausgeführt sein kann, wird die Rotationsbewegung zum Auslösen der Schaltvorgänge vorgenommen, wobei sich die Schaltkontakte nicht nur rotatorisch relativ zueinander bewegen, sondern zusätzliche Federkräfte wirken, um den Kontaktdruck im Schließzustand zu erhöhen. DE699835C1 offenbart eine Schalteinrichtung gemäß dem Oberbegriff des Anspruchs 1. Um das Ausschalten von insbesondere kleinen und mittleren Strömen in Schaltgeräten mit Löschkammern zu ermöglichen, werden bekannte Schaltgeräte mit unterstützenden Einrichtungen in Form von Permanentmagneten zur magnetischen Beblasung ausgerüstet. Diesbezüglich sei beispielsweise auf die US 2010/0126966A verwiesen.

Mit dem magnetischen Gleichfeld dieser Magnete soll das Einlaufen der Ausschaltlichtbögen in die Löschblechkammern bewirkt und beschleunigt werden. Die Wirkung der Magnete muss allerdings mit der Richtung des zu unterbrechenden Stroms abgestimmt sein, d.h. die Polung des Schaltgeräts muss beim Einbau in den Stromkreis beachtet werden. Dies schränkt die Freiheitsgrade bei der Installation ein oder es muss zusätzlich der Monteur über die exakte Installation des Schaltgeräts informiert werden. Bekannte Schaltgeräte des vorstehend beschriebenen Aufbaus sind auf Nennströme von einigen 10 A bei einer Nennspannung von etwa 1000 V beschränkt.

Bekannt sind darüber hinaus Mehrfachunterbrechungen, welche die Summe der Anoden-Kathoden-Spannungsfälle zum Aufbau einer ausreichend hohen Lichtbogenspannung nutzen. Dieses Prinzip ist in der DE 594 755 A offenbart. Abwandlungen finden sich in Lösungen des Standes der Technik beispielsweise gemäß WO 2009/121744 A oder der bereits erwähnten EP 2 107 581 A1. Derartige bekannte Schaltgeräte arbeiten mit einer Vielzahl von Unterbrechungsstellen, die gleichzeitig für einen Ausschaltvorgang getrennt werden.

Häufig werden vorhandene Ausführungen von Wechsel- bzw. Drehstromschaltgeräten für das Schalten in Gleichstromanwendungen, speziell auch für Photovoltaik-Anwendungen, ertüchtigt. Hierbei ergeben sich jedoch die im Folgenden erläuterten Problemstellungen.

In Solargeneratoren kommen üblicherweise keine großen Kurzschlussströme zum Fließen. Vielmehr sind die Kurzschlussströme zu beherrschen, die wenig größer als die Nennbetriebsströme sind. Je nach Art einer Sonneneinstrahlung variiert der Betriebsstrom in einem großen Bereich von wenigen Prozent des Nennbetriebsstroms bis zum Nennbetriebsstrom hin. Der Nennbetriebsstrom hängt außerdem von der Anlagengestaltung und dem beabsichtigten Ort, z.B. einer Strangleitung oder einer Gleichstrom-Hauptleitung in der Anlage ab und liegt typischerweise im Bereich von 10 A bis 100 A, bei Großanlagen gegebenenfalls auch darüber. Vorstehendes bedeutet, dass ein Schaltgerät im Gleichstromkreis einer Photovoltaik-Anlage keine Kurzschlussströme schalten muss, wie sie aus Wechselstromnetzen bekannt sind. Vielmehr geht es um das Schalten relativ kleiner Ströme. Dies ist wesentlich, da die Löschmechanismen bekannter Schaltgeräte für große Ströme auf diesen Anwendungsfall orientieren und die Löschung von Schaltlichtbögen kleinerer Ströme erschwert ist.

Solargeneratoren stellen schwach induktive Gleichstromkreise mit kleiner Zeitkonstante dar, in denen keine hohen Überspannungen beim Ausschalten entstehen. Dieser Charakter ist auch durch die hohe Eigenkapazität von Solaranlagen bedingt, die je nach eingesetzten Solarmodulen bei Großanlagen bis über 1 mF betragen kann. Diese hohen Eigenkapazitäten können auch kurze ohmsche-kapazitive Entladungen, z.B. bei einem Kurzschluss hervorrufen.

Weitere Anforderungen an Schaltgeräte für den Gleichstromkreis einer Photovoltaik-Anlage sind nachstehend dargelegt. Die Tragfähigkeit für Impulsströme mit hohen spezifischen Energiewerten, d.h. I²t-Werten, die aus einer möglichen Entladung von Kondensatoren in Wechselrichtern oder die aus einer Blitzeinwirkung auf die exponierte Photovoltaik-Anlage resultieren, ist notwendig. Das zu schaffende Schaltgerät muss diese kurzzeitigen Impulsströme mit Amplituden, die ein Vielfaches des Nennbetriebsstroms betragen können, sicher führen, ohne zu öffnen. Es müssen die dynamischen und thermischen Wirkungen der Impulsströme beherrscht werden, ohne dass eine Beschädigung bzw. eine unzulässige Änderung von Eigenschaften im Schaltgerät auftreten.

Darüber hinaus sind hohe Leerlaufspannungen des Solargenerators, die sich über Trennstrecken einstellen und die auch schon bei mäßiger oder geringer Sonneneinstrahlung vorliegen, zu beachten. Dies erfordert eine hohe Spannungsfestigkeit nach dem Verlöschen des Lichtbogens im Schaltgerät beim Ausschalten und eine ausreichende Kriechstromfestigkeit für hohe Gleichspannungen. Es sind also hier aufgrund des Einsatzes im Außenbereich große Trennstrecken notwendig.

Andererseits muß im Gleichstromkreis einer Photovoltaik-Anlage in der Regel nur geschaltet werden, wenn Wartungs-, Instandsetzungs- oder Erweiterungsmaßnahmen durchzuführen sind oder wenn ein Fehlerfall bzw. ein Brand vorliegt. Es kann also ein Schaltgerät auf wenige Schaltspiele ausgelegt sein.

Aus dem Vorstehenden ist es daher Aufgabe der Erfindung, eine kompakte Schalteinrichtung auf der Basis einer ein- oder mehrpoligen Schaltanordnung anzugeben, die wenigstens ein rotierendes Schaltelement aufweist, welches mit einem Antrieb in Verbindung steht. Die Schalteinrichtung soll direkt für Photovoltaik-Gleichstromkreise optimiert werden und auch für die Besonderheiten des Schaltens sowie des Betriebs von Photovoltaik-Gleichstromkreisen eingerichtet sein. Die Schalteinrichtung muss eine schnelle Drehbewegung zu einer Doppelunterbrechung mit effizienter Lichtbogenlöschung realisieren und im geöffneten Zustand, beim Schalten und im geschlossenen Zustand einen großen Bereich elektrischer Spannung und elektrischer Ströme entsprechend den Parametern der Photovoltaik-Anlage beherrschen. Darüber hinaus ist eine Möglichkeit zu schaffen, nicht nur für eine Unterbrechung des Gleichstromkreises, sondern auch zusätzlich für einen gezielten Kurzschluss zu sorgen. Es soll also die Schalteinrichtung in der Lage sein, nacheinander das Unterbrechen und das Kurzschließen auszuführen. Letztendlich muss die Schalteinrichtung positive Eigenschaften für den Betrieb der Photovoltaik-Anlage besitzen, nämlich eine kleine Verlustleistung im Dauerbetrieb und eine hohe Stoßstromtragfähigkeit aufweisen.

Hier ist zu beachten, dass die Stoßstromtragfähigkeit im Zusammenhang mit den Maßnahmen des Blitz- und Überspannungschutzes notwendig ist, wobei aufgrund von Ableitvorgängen große Stoßströme über die Schalteinrichtung fließen. Durch erfindungsgemäße Maßnahmen soll es gelingen, die Schalteinrichtung vor dem Erreichen des Lebensdauerendes in einen sicheren Zustand zu versetzen. Auch soll eine Möglichkeit dahingehend geschaffen werden, in die Schalteinrichtung Zusatzfunktionen, wie z.B. einen Überspannungs- oder Überstromschutz zu integrieren, ohne den Außenbauraum zu vergrößern.

Die Lösung der Aufgabe der Erfindung erfolgt durch eine ein- oder mehrpolige Schalteinrichtung gemäß der Merkmalskombination nach Patentanspruch 1, wobei die Unteransprüche mindestens zweckmäßige Ausgestaltungen und Weiterbildungen darstellen.

Es wird demnach von einer ein- oder mehrpoligen Schalteinrichtung für Gleichstromanwendungen in Photovoltaikanlagen mit mindestens einem rotierenden Schaltelement ausgegangen, welches mit einem Antrieb in Verbindung steht.

Weiterhin sollen Schaltkontakte, Anschlussstücke und Anschlusspole oder Anschlussklemmen vorhanden, wobei die vorgenannten Teile von einer Gehäuseanordnung aufgenommen werden.

Erfindungsgemäß ist in der Gehäuseanordnung ein beweglich geführter Drehzylinder ausgebildet, der sich in einem als Drehzylinderaufnahme ausgeführten Körper befindet.

Der als Drehzylinderaufnahme ausgeführte Körper kann hierbei Bestandteil des Gehäuses bzw. der Gehäuseanordnung sein.

Der Drehzylinder weist mindestens einen, den Drehzylinder bevorzugt radial oder aber auch tangential durchdringenden Kontaktbolzen auf, der an seinem Ende jeweils ein Kontaktstück besitzt. Der Kontaktbolzen ist entsprechend stromtragfähig ausgebildet und im Drehzylinder fixiert. Alternativ zum Bolzen sind auch anderweitig gestaltete, stromtragfähige Elemente einsetzbar.

In der Drehzylinderaufnahme sind Gegenkontakte angeordnet, welche mit den Anschlusstücken oder Anschlusspolen bzw. Anschlussklemmen in elektrischer Verbindung stehen.

Zwischen dem Drehzylinder und der Drehzylinderaufnahme besteht ein enger, lichtbogenbeeinflussender Luftspalt. Dieser Luftspalt besitzt eine Spaltbreite kleiner 200 µm, bevorzugt zwischen ca. 50 µm bis 100 µm. Infolge der Bewegung des Drehzylinders mit Kontaktbolzen ist die elektrische Verbindung zwischen den Kontaktstücken und den Gegenkontaktstücken aufhebbar. Die an beiden Kontaktstellen entstehenden Ausschaltlichtbögen dringen, einer Verlängerung unterliegend, in den Luftspalt ein und werden dort sehr schnell gelöscht. Mit anderen Worten werden die entstehenden Ausschaltlichtbögen sehr schnell in den engen Spalt überführt bzw. entstehen in diesem Spalt. Hierdurch kann der Ausschaltvorgang sehr schnell und mit geringem Energieumsatz erfolgen.

Erfindungsgemäß ist die Länge des Kontaktbolzens einschließlich der an ihm befindlichen oder dort ausgebildeten Kontaktstücke kleiner oder gleich dem Außendurchmesser des Drehzylinders. Es stehen also die Kontaktstücke des Kontaktbolzens nicht über die Außenoberfläche des Drehzylinders vor.

Mindestens Teile der Oberflächenabschnitte des Drehzylinders und/oder der Drehzylinderaufnahme bestehen an ihrem zum Luftspalt weisenden Bereich aus einem Löschgas abgebenden Material, insbesondere POM.

Die Gegenkontaktstücke sind mit einer Vorspannung in Richtung des Drehzylinders beaufschlagt und kontaktieren im geschlossenen Zustand der Schalteinrichtung die entsprechenden Kontaktstücke. Die Vorspannung kann durch eine Blattfeder oder dergleichen Mittel realisiert werden. Durch die Vorspannung ergibt sich eine entsprechende Kontaktkraft mit dem Kontaktübergangswiderstand.

Im Bereich der Gegenkontaktstücke ist erfindungsgemäß ausgestaltend mindestens ein Tastelement, z.B. ausgebildet als Tastnase, vorgesehen, welches an der Außenoberfläche des Drehzylinders anliegt und bei einer Drehbewegung in Öffnungsrichtung der Schalteinrichtung die Gegenkontaktstücke abhebt, wobei in Schließstellung der Schalteinrichtung das oder die Tastelemente in eine entsprechende Ausnehmung oder Vertiefung im Drehzylinder eintauchen.

Die zueinander weisenden Seiten der Kontakt- und Gegenkontaktstücke besitzen eine Halbkugel-, Pilzkopf- oder ähnliche abgerundete Form. Gemäß der Erfindung ist zwischen Drehzylinder und Drehzylinderaufnahme ein Blockierelement vorgesehen, welches sich in einer Führung befindet, deren Öffnung dann freigegeben wird, wenn ein Verschleiß des die Öffnung verschließenden Materials eintritt, wobei das Blockierelement dann in eine komplementäre Ausnehmung eingreift, um erneute Schaltvorgänge zu unterbinden. Das Blockierelement soll grundsätzlich beim Öffnungsvorgang ausgelöst werden, wobei dann die vollständige Blockierung im Aus-Zustand der Schalteinrichtung gegeben ist. Das Auslösen des Blockierelements kann mit einer optischen Anzeige oder einer Fernmeldeanzeige in Verbindung stehen.

In einer Einebenen- oder einer Zweiebenen-Anordnung wird nach einem Öffnungsvorgang der Schalteinrichtung mit Hilfe des ersten oder eines zweiten Kontaktbolzens eine Kurzschlussfunktion auslösbar, wobei hierfür in der Drehzylinderaufnahme weitere Gegenkontaktstücke angeordnet sind, die mit weiteren Anschlussstücken oder Anschlussbolzen bzw. Anschlussklemmen in elektrischer Verbindung stehen.

Diesbezüglich ausgestaltend ist in einer ersten Ebene im Drehzylinder der Kontaktbolzen für das Öffnen und Schließen und in einer zweiten Ebene im Drehzylinder der Kontaktbolzen für das Kurzschließen befindlich, wobei die Kontaktbolzen unter einem Winkel zueinander versetzt angeordnet sind. Das Kurzschließen erfolgt demnach zeitlich versetzt nach dem Trennen bzw. Öffnungsvorgang der Schalteinrichtung. Dieser Zeitversatz wird durch die mechanische Anordnung der Drehbewegung und das schnelle Löschen der Lichtbögen beim Öffnungsvorgang gewährleistet. Der Zeitversatz ist insofern wesentlich, als dass eine stromstarke Entladung von Eingangskondensatoren eines Wechselrichters von Solaranlagen über die Trennungslichtbögen beim Öffnungsvorgang vermeidbar ist.

Die Abbrandkontakte in der rotatorischen Schalteinrichtung sind vorteilhaft so anordenbar, dass die Ausschaltlichtbögen sich sofort nach ihrer Entstehung in einem engen Isolierstoffspalt befinden.

Bevorzugt kann der Kurzschluss-Kontaktbolzen einen vorgegebenen Wirkwiderstand aufweisen.

Bei einer Ausgestaltung der Erfindung kann die Schalteinrichtung den Gegenkontaktstücken und/oder den Kontaktstücken benachbarte Abbrandkontakte aufweisen.

Die Stromzuführung zu den Gegenkontaktstücken ist über die Anschlussstücke unter Nutzung der Lorentzkraft bei fließenden Impulsströmen ausführbar derart, dass eine Verstärkung der Kontaktkraft zwischen Kontaktstück und Gegenkontaktstück bei entsprechendem Stromfluss gegeben ist.

In den zueinander weisenden Oberflächen von Drehzylinder und Drehzylinderaufnahme sind bei einer Weiterbildung der Erfindung Kriechstreckenvergrößernde Rücksprünge oder Ausnehmungen vorgesehen, welche je nach Drehlage offene oder quasi geschlossene Luftstrecken bilden.

Wiederum ausgestaltend kann der Drehzylinder Hohlräume zur Aufnahme von zusätzlichen Schaltelementen wie Sicherungen, überspannungsbegrenzenden Halbleitern oder dergleichen Bauelemente aufweisen.

Zum elektrischen Anschluss der in den Hohlräumen befindlichen Bauelemente sind zusätzliche Kontaktstücke und Gegenkontaktstücke vorhanden.

Erfindungsgemäß ist darüber hinaus eine Kontaktanordnung, die ein Paar drehbeweglicher Kontaktstücke sowie ein Paar feststehender Gegenkontaktstücke aufweist. Die zueinander weisenden Oberflächen der Kontaktstücke und Gegenkontaktstücke besitzen eine Halbkugel-, Pilzkopf- oder dergleichen abgerundete Form. Bei einer Relativbewegung durch Verschwenken oder Verdrehen treten die sich ansonsten zentral berührenden Oberflächenabschnitte außer Kontakt und es bilden sich zwischen den sich voneinander entfernenden Rändern jeweils Lichtbögen, welche in einen Ringspalt gezogen werden, der geometrie- und bewegungsbedingt zwischen Kontaktstück und Gegenkontaktstück entsteht.

Die Erfindung soll nachstehend anhand von Ausführungsbeispielen sowie unter Zuhilfenahme von Figuren näher erläutert werden.

Hierbei zeigen:
- Fig. 1 und 2: Spannungs-Stromkennlinien beim Schalten verschiedener Quellen;
- Fig. 3: einen Querschnitt der erfindungsgemäßen Schalteinrichtung der ersten Ausführungsform;
- Fig. 4: einen Längsschnitt der erfindungsgemäßen Schalteinrichtung der ersten Ausführungsform;
- Fig. 5: eine Darstellung ähnlich derjenigen nach Fig. 3, jedoch mit beginnendem Ausschaltvorgang durch Ausführen einer Drehbewegung;
- Fig. 6: eine Darstellung der Schalteinrichtung ähnlich derjenigen nach Fig. 4, jedoch hier im ausgeschalteten Zustand;
- Fig. 7: eine Darstellung ähnlich derjenigen nach Fig. 5 einer Schalteinrichtung im Querschnitt im ausgeschalteten Zustand;
- Fig. 8a und 8b: eine Darstellung der erfindungsgemäßen Schalteinrichtung im Querschnitt, wobei Fig. 8a den geschlossenen Schaltzustand und Fig. 8b den geöffneten Schaltzustand mit ausgelöstem Blockierelement zeigt;
- Fig. 9: ein Blockschaltbild einer Photovoltaik-Anlage nebst eingesetzter erfindungsgemäßer einpoliger Schalteinrichtung im Gleichstromzweig nach dem Solargenerator bzw. vor dem Wechselrichter;
- Fig. 10: ein Blockschaltbild mit der Anordnung von einer Schalteinrichtung 1 als Öffner und Schließer sowie einer Kurzschlusseinrichtung 2;
- Fig. 11: eine Ausführungsform der erfindungsgemäßen Schalteinrichtung als Schalter und Kurzschließer in einer Ebene im Querschnitt;
- Fig. 12: eine Ausführungsform der erfindungsgemäßen Schalteinrichtung als Schalter und Kurzschließer in zwei Ebenen im Längsschnitt;
- Fig. 13: eine prinzipielle Darstellung der Ausführungsform der Anschlussstücke nebst Gegenkontaktstücken und deren Stromzuführung unter Ausnutzung der Lorentzkraft;
- Fig. 14: eine Darstellung der erfindungsgemäßen Schalteinrichtung im Querschnitt mit zusätzlichen Abbrandkontakten;
- Fig. 15: zwei Abbildungen einer Weiterbildung der erfindungsgemäßen Schalteinrichtung im Querschnitt mit offenen (linksseitig) und geschlossenen (rechtsseitig) ausgebildeten Luftstrecken;
- Fig. 16: eine Darstellung der erfindungsgemäßen Schalteinrichtung im Längsschnitt mit erkennbarem Hohlraum zur Aufnahme eines Überspannungsschutzelements und ein Blockschaltbild der elektrischen Einbindung dieses Überspannungsschutzelements und
- Fig. 17 und 18: eine weitere Ausführungsform der erfindungsgemäßen Schalteinrichtung im Längsschnitt mit Hohlraum zur Aufnahme einer Sicherung sowie rechtsseitig (Fig. 18) Detaildarstellungen der Kontaktanordnung zur elektrischen Einbindung der Sicherung;
- Fig. 19: eine Prinzipdarstellung einer einpoligen Hybridschalteinrichtung mit Doppelunterbrechung und Unterstützung durch einen Halbleiterschalter, der am mitdrehendem Kontaktbolzen angeschlossen ist, mit einem Halbleiterschaltelement z.B. IGBT 25;
- Fig. 20: eine einpolige Hybridschalteinrichtung mit vierfacher Unterbrechung und Unterstützung durch einen Halbleiterschalter über einer der Doppelunterbrechungen;
- Fig. 21: ein Prinzipschaltbild einer zweipoligen Unterbrechung in Längsrichtung, wobei ein Pol die Leistungsschaltung vornimmt und hybridunterstützt wird durch einen Halbleiterschalter mit einem zweiten Pol, der nahezu leistungslos trennt;
- Fig. 22: eine Prinzipdarstellung einer zweipoligen Unterbrechung in Längsrichtung mit Kurzschlussschaltung im Querzweig jeweils hybrid mit Unterstützung durch einen Halbleiterschalter;
- Fig. 23: ein Prinzipschaltbild einer einpoligen Unterbrechung längs mit Kurzschluss im Querzweig, wobei die Kurzschlussunterstützung durch einen Halbleiterschalter mit Ansteuerung von einer Unterbrechungseinrichtung vorgenommen wird;
- Fig. 24: ein Prinzipschaltbild einer zweipoligen Unterbrechung im Längszweig und Kurzschluss im Querzweig mit Kurzschlussunterstützung durch einen Halbleiterschalter, der wiederum von einer Unterbrechungseinrichtung angesteuert wird, und
- Fig. 25: ein Prinzipschaltbild einer einpoligen doppelten Unterbrechung im Längszweig mit Kurzschlussunterstützung im Querzweig durch einen Halbleiterschalter.

Das Schalten, insbesondere Ausschalten, sowie das Verhalten von Lichtbögen in Gleichstromkreisen von Photovoltaik-Anlagen unterscheidet sich signifikant von dem in Gleichstromkreisen mit linearer Zweipol-Kennlinie (Akkumulatoren, Batterien, Gleichrichteranlagen oder Gleichstromgeneratoren als Quellen) oder von dem in Wechselstromkreisen.

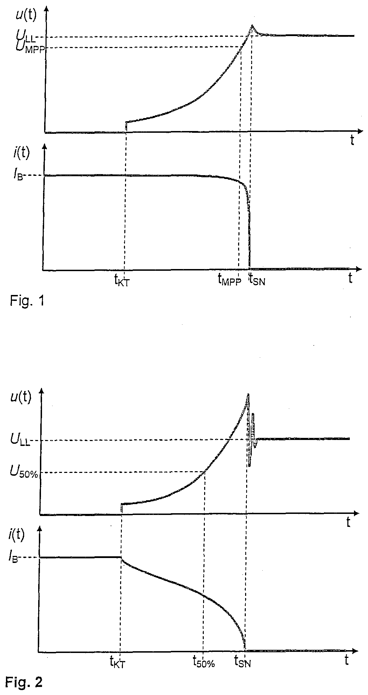

Die Besonderheit von Solargeneratoren ist die Eigenschaft näherungsweise als Konstantstromquelle mit hohem Innenwiderstand zu wirken, was günstige Existenzbedingungen und damit eine hohe Stabilität für Stör- wie auch SchaltLichtbögen bedeutet. Dies drückt sich in der nichtlinearen Spannungs-Strom-Kennlinie aus, die beim Ausschalten von Gleichströmen in PV-Anlagen relevant ist. An Photovoltaik-Quellen tritt beim Ausschalten ein nahezu konstanter Strom auf, bis die Lichtbogenspannung (u_{LB}) größer als etwa die Spannung im Punkt maximaler Leistung (U_{MPP}) geworden ist (Fig. 1). Damit wird der Lichtbogen erst instabil und der Strom reduziert, wenn im Schaltgerät eine Lichtbogenspannung von größer 70 % bis 90 % der Leerlaufspannung (U_{LL}) des Solargenerators aufgebaut ist. Im Gegensatz dazu tritt in Kreisen mit linearen Zweipol-Quellen eine Verringerung des Stromes schon unmittelbar nach Lichtbogenentstehung auf und der Lichtbogen wird bei einer Lichtbogenspannung (U_{50%}) größer 50 % der treibenden Quellenspannung (U_{LL}) bereits instabil (Fig. 2).

Im Vergleich treten in Kreisen mit Photovoltaik-Quellen im allgemeinen lange Schalt- bzw. Lichtbogenzeiten und damit, sowie verstärkt durch den lange konstant hohen Strom, eine hohe Schaltarbeit bei Nennleistung eines Schaltgerätes auf. Eine hohe Schaltarbeit bedeutet gemeinhin eine hohe thermische Beanspruchung des Schaltgerätes sowie einen erhöhten Abbrand von Schaltkontakten und Löscheinrichtungen verbunden mit beschleunigter Alterung.

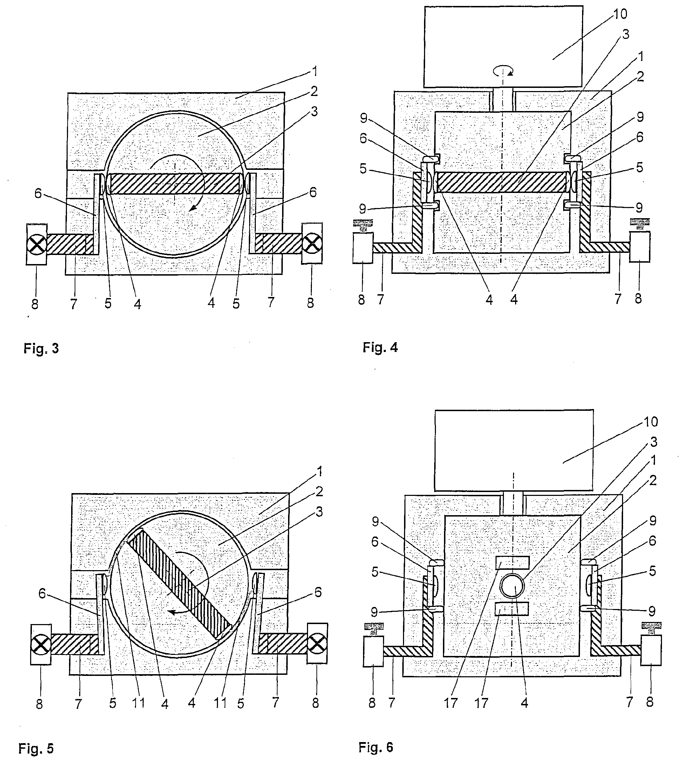

Nachstehend wird gemäß Ausführungsbeispiel eine Schalteinrichtung beschrieben, welche speziell für die eingangs genannten Anforderungen im Gleichstromteil von Photovoltaik-Anlagen ausgelegt ist und die erwähnten Nachteile nicht besitzt. In der sehr einfach gestalteten Schalteinrichtung wird das Ausschalten mit einer Drehbewegung realisiert (Fig. 3, Fig. 4). Eine Doppelunterbrechung ohne Löschkammer und ein enger Spalt um einen Isolierstoffzylinder, der sich in der Bohrung eines Isolierstoffblocks dreht, bewirken eine starke Beeinflussung der Bogenspannung und schließlich die Löschung des Ausschaltlichtbogens. Mit einem Pol, der nur zwei Unterbrechungsstellen aufweist, erfolgt die Stromunterbrechung auch bei hohen Gleichspannungen. Somit ist keine Verschaltung von Polen erforderlich, es ergibt sich eine sehr kompakte Ausführung. Der Verdrahtungsaufwand in und an der Schalteinrichtung ist gering. Da nur ein nahezu direkter Stromweg in der Schalteinrichtung vorliegt, ist eine ungünstige gegenseitige Beeinflussung von Stromfaden nicht gegeben. Außerdem liegt aufgrund der geringen Anzahl von Komponenten, insbesondere beweglichen Teilen, nur eine geringe Störanfälligkeit vor.

Anhand der Grafiken Fig. 3 und Fig. 4 soll der Aufbau der Schalteinrichtung in ihrer grundlegenden Ausführung dargestellt werden.

Fig. 3 zeigt einen Schnitt durch die Schalteinrichtung als Draufsicht und Fig. 4 einen Schnitt als Seitenansicht, bei beiden befindet sich die Schalteinrichtung im Ein-Zustand (Stromweg geschlossen).

Um einen Drehzylinder 2, der mindestens an seinem Umfang aus einem gasabgebenden Kunststoff besteht, befindet sich die Zylinderaufnahme 1 mit einem Loch, das als Durchgangsbohrung oder als Bohrung mit bestimmter Tiefe ausgeführt sein kann. Zwischen der Innenwandung des Loches der Zylinderaufnahme 1, die wiederum mindestens an ihrem inneren Umfang aus einem gasabgebenden Kunststoff besteht, und dem in die Zylinderaufnahme 1 gesteckten Zylinder 2 befindet sich ein Luftspalt kleiner definierter Breite. Die Spaltbreite wurde so gewählt, dass sich ein Optimum ergibt im Hinblick auf die Lichtbogenbeeinflussung, die eine kleine Spaltbreite erfordert, auf die Drehgeschwindigkeit bzw. die Reibung des Drehzylinders 2 sowie die temperaturabhängigen Längen- und Volumenausdehnungen, die eine größere Spaltbreite notwendig machen.

Aus Versuchsreihen wurde eine geeignete Spaltbreite ermittelt, die zwischen kleiner 200µm, bevorzugt 50 und 100 µm liegt, wobei zusätzlich die mögliche Ablagerung von Abbrandprodukten und das Abströmen von Löschgas Berücksichtigung fand. In der Mitte des Drehzylinders 2 und rechtwinklig zur Drehachse ist in einer Durchgangsbohrung ein Durchgangsbolzen 3 angeordnet, der an beiden Stirnseiten je ein mitdrehendes Kontaktstück (innen) 4 besitzt. Drehzylinder und Zylinderaufnahme können, wie dargelegt, teilweise oder vollständig aus gasabgebendem Kunststoffmaterial bestehen. Ebenso ist es denkbar, dass die vorerwähnten Teile kombiniert aus abbrandfestem und gasabgebendem Material oder nur aus einem abbrandfesten, teilweise gasabgebenden Material bzw. nur gasabgebenden Kunststoff bestehen. Damit bleibt die gewünschte definierte Spaltbreite über den Einsatzzeitraum der Schalteinrichtung weitgehend erhalten.

Die Länge des Durchgangsbolzens 3 einschließlich der Kontaktstücke 4 ist gleich dem Außendurchmesser oder um 100 bis 200 µm kleiner als der Außendurchmesser des Drehzylinders 2. In der Wandung der Zylinderaufnahme 1 sind einander gegenüberliegend zwei kreisrunde Durchbrüche rechtwinklig zur Bohrungsachse für den Durchgriff der festen Kontaktstücke (außen) 5 vorhanden. An den Enden von vorzugsweise als Blattfedern ausgeführten Federelementen 6 sind die festen Kontaktstücke (außen) 5 und die Halterungen für die Abhebeelemente 9 angebracht.

Die festen Kontaktstücke (außen) 5 mit kreisrundem Querschnitt drücken aufgrund einer definierten Federkraft von einigen Newton auf die mitdrehenden Kontaktstücke (innen) 4, die ebenfalls einen kreisrunden Querschnitt aufweisen, und stellen so im Ein-Zustand den Stromfluss sicher. Dies ist möglich, weil die Tast- oder Abhebeelemente 9 über den Ansatzflächen 17 stehen, die in die Umfangsfläche des Drehzylinders 2 in den Umgebungen der Durchgangsbohrung für den Durchgangsbolzen 3 mit den mitdrehenden Kontaktstücken 4 ausgearbeitet sind.

Über die Anschlussklemmen 8 und die vorzugsweise winkligen Anschlussstücke 7 erfolgt die Stromzuführung zu den Kontaktstücken 5. Die Anschlussstücke 7 wie auch die Federelemente 6 weisen für das jeweils verwendete Material mit bestimmter Leitfähigkeit einen ausreichenden Querschnitt zum Führen von Dauer- und Impulsströmen auf. Damit werden eine genügende mechanische Festigkeit bei Impulsströmen und eine minimale Erwärmung bei Dauerstrom (Nenn- bzw. Überstrom der Schalteinrichtung) erreicht. Je ein Anschlussstück 7 ist zusammen mit einem Federelement 6 auf gegenüberliegenden Seiten an der Zylinderaufnahme 1 starr befestigt. Am Drehzylinder 2 ist zentrisch an einer Stirnseite eine Möglichkeit geschaffen, dass die Drehbewegung des Antriebes 10 ohne wesentlichen Kraftverlust und Drehwegverzug auf den Drehzylinder 2 übertragen werden kann. Der Drehantrieb 10 ist starr mit der Zylinderaufnahme 1 verbunden, so dass eine Drehung des Drehzylinders 2 als Relativbewegung zur Zylinderaufnahme 1 auftritt.

In Fig. 5 ist der Schnitt einer Draufsicht während des Ausschaltvorganges mit vorhandenem Ausschaltlichtbogen dargestellt.

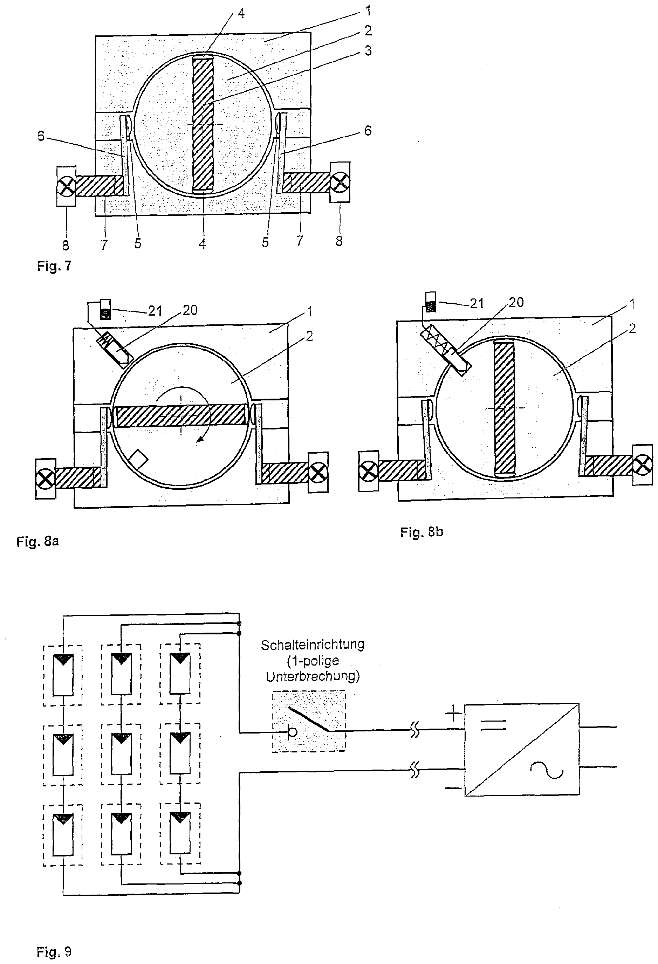

Den Aus-Zustand (Stromweg geöffnet) der Schalteinrichtung zeigen die Fig. 6 als Schnitt einer Seitenansicht und Fig. 7 wieder als Schnitt einer Draufsicht.

Mit Hilfe der Fig. 3 bis Fig. 7 kann der Ausschaltvorgang beschrieben werden. Die Ausführung der Unterbrechungsstellen bzw. der Schaltkontakte sowie die Gestaltung der zylindrischen Drehanordnung führen dazu, dass sich die bei Kontakttrennung entstehenden Lichtbögen sofort im engen Spalt befinden und somit unmittelbar nach ihrer Entstehung beeinflusst werden. Dies bedingt eine schnelle Erhöhung der Bogenspannung. Die Doppelunterbrechung in der Schalteinrichtung bewirkt aufgrund der gleichzeitigen schnellen Verlängerung und Beeinflussung von zwei Lichtbögen eine kurze Lichtbogenzeit und eine geringe energetische Beanspruchung der Schalteinrichtung. Zudem können die Kontaktelemente, die mit den nach außen führenden Anschlüssen verbunden sind, so ausgeführt werden, dass nur eine geringfügige Bewegung (< 0,5 mm) notwendig wird.

Aufgrund der Drehbewegung und der Unterbrechergestaltung werden die mitdrehenden Kontaktstücke 4 und die festen Kontaktstücke 5 nur an ihren Rändern vom Lichtbogen beansprucht und dort beim Schaltvorgang geschädigt. Der zentrale Bereich der Kontaktstücke, über den im geschlossenen Zustand der Schalteinrichtung der Dauerstrom fließt, erfährt keine wesentliche Lichtbogenbeanspruchung. Damit bleibt ein niedriger Kontaktwiderstand erhalten, die Verluste und die Dauerstromerwärmung werden reduziert.

Beginnt, angetrieben durch den Drehantrieb 10, die Rotationsbewegung des Drehzylinders 2, dann gleiten die mitdrehenden Kontaktstücke (innen) 4 noch bis zu einem kleinen Drehwinkel auf den festen Kontaktstücken (außen) 5 bis sich gegenüberliegend jeweils die Kontaktstücke trennen. Mit dieser Trennung entstehen zwei Lichtbögen, die erst in einigen 100 µs in einen stabilen Brennzustand übergehen. Während dieser Zeit setzt sich die Drehbewegung mit hoher Drehgeschwindigkeit fort und es kommt zur Verlängerung beider Lichtbögen und unmittelbar zum Hineinziehen der Lichtbögen in den engen Spalt zwischen dem Loch in der Zylinderaufnahme 1 und dem Drehzylinder 2, wodurch die Lichtbögen einen sehr flachen breiten Querschnitt annehmen müssen. Gleichzeitig wirken die Lichtbögen auf die Isolierstoffoberflächen des Drehzylinders 2 und der Innenwandung der Zylinderaufnahme 1 mit ihrer hohen Temperatur ein und es beginnt die oberflächige Zersetzung des stark gasenden Isolierstoffes. Unmittelbar nach der Kontakttrennung laufen die Abhebeelemente 9 von den Ansatzflächen 17 ab und schleifen dann auf der runden Drehzylinderoberfläche, wodurch sich die Kontaktstücke für die weitere Drehbewegung wenige 100 µm über der Drehzylinderoberfläche befinden. Da die Kontaktstücke die Zylinderoberfläche nicht berühren können, kann sich kein (geschmolzenes) Kontaktmaterial durch Reibung auf der Oberfläche anlagern, was die Überschlagsfestigkeit herabsetzen würde.

Durch die Einengung der Lichtbögen im Spalt und die Gasentwicklung tritt eine Druckerhöhung auf, so dass die Lichtbogenfeldstärke stark zunimmt. Außerdem bewirkt die enge Berührung der Lichtbögen mit den Isolierstoffoberflächen die Kühlung der Lichtbögen, welche ebenfalls zu einer Erhöhung der Lichtbogenfeldstärke beiträgt.

Zusammen mit der Verlängerung der Lichtbögen führen die Druckerhöhung und die Kühlung zu einer schnell ansteigenden Vergrößerung der Lichtbogenspannung (siehe Fig. 1). Schon nach wenigen Grad der Drehung des Zylinders 2, was einer Dauer von z.B. 1 bis 3 ms entspricht, wird so bei hohen elektrischen Parametern (1500 V, 100 A) des vorliegenden Gleichstrom-PV-Kreises eine Lichtbogengesamtspannung in der Schalteinrichtung aufgebaut, die in der Höhe der treibenden Quellenspannung (Leerlaufspannung) liegt. Damit wird der Strom schnell zu Null geführt und der Gleichstromkreis unterbrochen. Insbesondere wegen des unmittelbar nach Stromnull noch vorhandenen Löschgases vom Isolierstoff und dessen Abströmen aus dem vorherigen Lichtbogenbereich kommt es zu einer raschen Entionisierung beider Schaltstrecken, zu einer schnellen Wiederverfestigung der Schaltstrecken und deshalb zum Aufbau einer sicheren Trennstrecke durch die Schalteinrichtung.

Wenn die elektrischen Parameter des Gleichstrom-PV-Kreises, in dem ausgeschaltet werden soll, kleiner als die Nennwerte der Schalteinrichtung sind, dann tritt die Lichtbogenlöschung schon bei einem kleineren Drehweg und damit nach einer kürzeren Lichtbogenzeit auf und die Menge an in Gas umgesetzten Isolierstoffes ist reduziert. Deutlich kleinere elektrische Parameter als die Nennwerte führen sogar zu einer Löschung der Lichtbögen während ihrer Stabilisierungsphase, die Lichtbogendauer beträgt in diesem Fall nur maximal 1 ms.

Ein hervorzuhebender Vorteil der beschriebenen Schalteinrichtung ist es, dass der Lichtbogen vor der Löschung beim Ausschalten im allgemeinen nicht das thermische Gleichgewicht erreicht. In Abhängigkeit von Schaltstrom und Schaltspannung kann man davon sprechen, dass nur ein elektrischer Funke anstatt eines stabilen Lichtbogens auftritt. Damit ist im Vergleich zu bekannten Schaltgeräten, in denen in aller Regel dort vorliegende thermisch stabile Lichtbögen zu löschen sind, der Aufwand, welcher in der Schalteinrichtung zur Stromunterberechung zu treiben ist, verhältnismäßig gering.

Trotz Abgabe von Gas bei der Lichtbogeneinwirkung auf den Isolierstoff entsteht keine massive gerichtete Gasströmung, weil die Gasentstehung und die einhergehende Druckerhöhung nur sehr kurzzeitig auftreten. Aus dem Lichtbogenraum strömt deshalb kein heißes Gas ab. Daher sind keine Gaskanäle und auch keine Kühlung (bzw. Entionisierung) von heißem Gas notwendig.

Der in der vorgeschlagenen Schalteinrichtung gezogene Lichtbogen kann in seiner Bewegung, in seiner Form und in seiner Länge durch äußere Einflüsse, wie elektromagnetische Kräfte aufgrund von Stromschleifen oder von Permanentmagneten, kaum beeinflusst werden. Der Lichtbogenraum bzw. der Lichtbogenweg werden durch den inneren Aufbau der Schalteinrichtung fest vorgegeben, so dass sich dem Lichtbogen nur wenig Raum bietet, kürzere Wege zufinden oder seinen Querschnitt zu vergrößern. Damit besitzt die Schalteinrichtung ein reproduzierbares Schalt- und Lichtbogenverhalten, d.h. bei gegebener Schaltspannung und gegebenem Schaltstrom treten über mehrere Ausschaltungen Lichtbogenzeiten und -energien mit geringer Streuung auf.

Die Lichtbogenlöschung wird wesentlich durch die Gasabgabe vom Isolierstoff unterstützt. Dazu ist ein Isolierstoff einzusetzen, der bereits bei geringen Temperaturen, d.h. bereits bei Lichtbogenentstehung, ausreichende Mengen an geeigneten Gasen abgibt. Die Gasabgabe darf nicht mit der Bildung von leitfähigen Zersetzungsprodukten oder leitfähigen Schichten einhergehen (Berußung, Spannungsfestigkeit, Trennstrecke) oder zur Bildung von aufgerauten Isolierstoffoberflächen führen (Bremsung der Drehbewegung). Als besonders geeignet hat sich der Kunststoff Polyoxymethylen (POM) herausgestellt, der sowohl eine gute Kühlung der Lichtbögen als auch die Bindung von Kohlenstoff durch frei werdenden Wasserstoff und Sauerstoff bewirkt. Zudem besitzt dieser Kunststoff eine gute Schmierfähigkeit und bei Einwirkung des Lichtbogens bleibt eine glatte Oberfläche zurück.

Eine Gasabgabe vom Isolierstoff bei Lichtbogeneinwirkung bedeutet den Abbrand von Isolierstoff und damit eine Vergrößerung des engen Spalts. Der Abbrand beginnt im vorderen Bereich des vorhandenen Drehweges und setzt sich mit der Anzahl an Lastausschaltungen am Umfang des Drehzylinders und an der Innenwandung der Bohrung im Isolierstoffblock fort. Da beim vorgesehenen Einsatz der Schalteinrichtung in Photovoltaik-Anlagen ein häufiges Schalten nicht erforderlich ist, ergibt sich aus dem Abbrand kein Nachteil. Wenn der Abbrand für bestimmte Schaltaufgaben nachteilig ist, dann können ein anderes Isolierstoffmaterial oder eine Materialkombination eingesetzt werden, die einen geringeren Abbrand bei Lichtbogeneinwirkung aufweisen.

Um dem erhöhten Sicherheitsbedürfnis von Photovoltaik-Anlagen Rechnung zu tragen, wird zudem vorgeschlagen, eine einfache Sensorik zur Überwachung des Abbrandes in der Schalteinrichtung einzusetzen, die beim Erreichen einer vordefinierten Grenze den Schaltmechanismus blockiert und diesen Zustand zur Anzeige bringt. Die Grenze wird auf einen Abbrandwert weit vor dem Erreichen der Lebensdauer eingestellt. In einfacher Weise kann dazu beispielsweise eine örtlich definierte Stelle in der Wandung des Loches der Zylinderaufnahme 1 mit einer geringen Wanddicke ausgeführt sein (erkennbar in Fig. 8a), die aufgrund des Abbrandes in ihrer Stärke abnimmt und bei entsprechender Abbrandtiefe ein Blockierelement freigibt, welches nur im Aus-Zustand wirksam werden kann und dabei den Drehzylinder 2 feststellt. Das Blockieren erfolgt somit für den geöffneten Zustand (Stellung Aus) und bewirkt, dass die Schalteinrichtung nicht mehr geschlossen (eingeschaltet) werden kann (Fig. 8b). Weitere elektrische oder optische Verfahren sind anwendbar, die den Abbrandzustand im Hinblick auf die vorhandene Restlebensdauer erfassen und gegebenenfalls die Blockierung auslösen. Vor Ort oder in Ferne wird die Blockierung angezeigt.

Die definierte Stelle in der Wandung der Zylinderaufnahme kann in der Mitte der Höhe der Zylinderbohrung und z.B. bei ≤45° (halber Drehweg) angeordnet werden. Bei einer Spaltaufweitung an dieser Stelle von z.B. 0,1mm auf ca. 0,3mm wird das Blockerelement freigegeben. Hierfür weist die Stelle in der Wandung der Zylinderaufnahme eine geringe Wanddicke von z.B. 0,2mm auf. Da der Materialverschleiß nicht gleichmäßig am Umfang der Bohrung der Zylinderaufnahme und des Drehzylinders auftritt, sondern von 0° bis 45° und darüber hinaus abnimmt, sollte diese Wanddicke am Blockierelement vergleichsweise gering gewählt werden. Hier kann man sich die Materialabnahme am Umfang von der Zylinderaufnahme und vom Drehzylinder so vorstellen, dass der Luftspalt sich quasi keilförmig vergrößert.

Im Aus-Zustand erfüllt die Schalteinrichtung dann vollständig die Kriterien einer Trennstelle. Einrichtungen, die eine Fernmeldung des aktuellen Zustandes der Schalteinrichtung (Stellung Ein, Aus oder Blockiert) ermöglichen, können vorgesehen werden.

Beim Schalten der Schalteinrichtung kann die Drehrichtung für den Aus- und den Einschaltvorgang entgegengesetzt sein oder eine vorgegebene Drehrichtung kann durchgängig für alle Schaltvorgänge beibehalten werden. Außerdem ist es möglich, immer nach zwei aufeinanderfolgenden Schaltvorgängen (Aus und Ein oder Ein und Aus) die Drehrichtung zu wechseln, was zu einer Halbierung der Lichtbogenbeanspruchung der Isolierstoffwände am engen Spalt führt und zugleich eine symmetrische Abnutzung der Kontaktstücke bedeutet.

In der vorgeschlagenen Schalteinrichtung kann in einfacher Weise das Abheben der äußeren, federnd gelagerten, Kontaktstücke (Gegenkontaktstücke) von dem drehenden Isolierstoffzylinder während der Drehbewegung bewirkt werden, um das Schleifen dieser Kontaktstücke auf dem Isolierstoffzylinder zu vermeiden. Damit wird die Bildung leitfähiger Spuren auf der Oberfläche des Isolierstoffzylinders verhindert und im Aus-Zustand eine hochohmige Trennstrecke sichergestellt.

Das Abheben wird dadurch realisiert, dass an jedem äußeren Kontaktstück seitlich ein oder zwei Abhebeelemente aus Isolierstoff (Kunststoff) befestigt sind, welche die Umfangsfläche des Isolierstoffzylinders ständig berühren. Vertiefte Ansatzflächen, die sich im Bereich des mitdrehenden Kontaktstücks auf dem Umfang des Isolierstoffzylinders befinden, ermöglichen die Kontaktberührung. Dreht sich der Zylinder, dann laufen die Abhebeelemente von den Ansatzflächen auf die nicht vertiefte Umfangsfläche des Isolierstoffzylinders ab, wobei die Kontaktstücke angehoben werden.

Die vorgeschlagene DC-Lasttrennschalteinrichtung kann zur Abschaltung bzw. Freischaltung im PV-Gleichstromhauptkabel/-leitung (auf der DC-Seite des PV-Wechselrichters; siehe Fig. 9), in PV-Teilgeneratorkabeln/-leitungen (mehrere Stränge/Strings zusammengefasst) oder in PV-Strangkabeln/-leitungen (im oder am Strang/String) eingebracht werden. Der vorrangige Einsatz ist in industriellen PV-Anlagen, wie Großanlagen oder PV-Kraftwerken, mit hohen Nennspannungen, beispielsweise im Bereich von 600 V bis 1500 V, und hohen Nennströmen, typisch im Bereich von einigen 10 A bis wenige 100 A, zu sehen. Für diese hohen elektrischen Parameter wird die Schalteinrichtung mit einer Spaltbreite vorzugsweise kleiner als 0,1 mm zwischen den Teilen aus gasendem Isolierstoff, vorzugsweise Polyoxymethylen (POM), ausgelegt. Die mittlere Umfangsgeschwindigkeit soll mehr als etwa 4 m/s bei einem Gesamtumfangsweg von mindestens 20 mm betragen, wobei sich ein näherungsweise linearer Anstieg der Lichtbogenspannung von über 100 V/mm Umfangsweg bzw. über 400 V/ms ergibt. Die Schalteinrichtung ist primär nicht auf häufiges, sondern auf gelegentliches Schalten ausgelegt, wobei sich die Anzahl der Schaltspiele (Ein- und Ausschalten) bei im Vergleich zu den Nenngrößen reduzierten Spannungen und Strömen erhöht.

Bei einem Fehlerfall in einer Photovoltaik-Anlage stellt ein Kurzschluss des Solargenerators meist den sichersten Zustand her. Dies gilt auch im Hinblick auf die Sicherheit beim Löschen von Bränden durch die Einsatzkräfte der Feuerwehr.

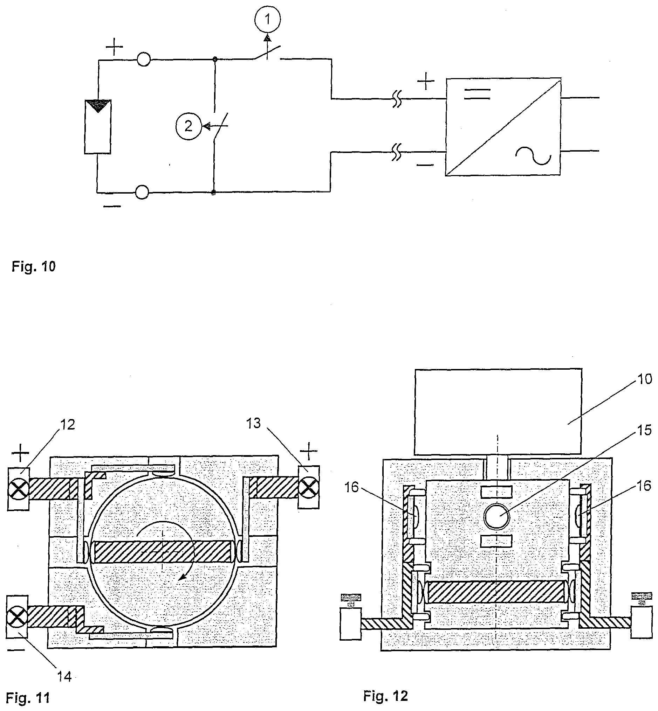

Eine günstige Ausgestaltung der Schalteinrichtung ist deshalb die Kombination der Trennschalteinrichtung mit einem Kurzschließer für Gleichstromkreise von PV-Anlagen (gemäß Fig. 10).

Eine Erweiterung kann so gestaltet sein, dass beim Schaltvorgang zuerst die Auftrennung einer Längsstrecke (z.B. in der Plus-Leitung) und danach das Kurzschließen einer Querstrecke (z.B. zwischen Plus- und Minus-Leitung) erfolgt, wobei eine unmittelbare mechanische Kopplung vorliegt. Eine mögliche Ausführung ist eine Einebenen-Anordnung (Fig. 11), bei welcher zusätzliche äußere Kontaktstücke für das Kurzschließen um 90° gedreht gegenüber den vorhandenen äußeren Kontaktstücken für das Unterbrechen eingesetzt werden. Auch eine zwei- oder mehrpolige Ausführung mit zwei oder mehr Ebenen ist realisierbar (Fig. 12). Beide Ausführungen können mit einem Antrieb realisiert werden.

Da die Elemente zum Kurzschließen analog zu den Elementen für das Aus- und Einschalten gestaltet sind, ist es mit der Schalteinrichtung möglich, den hergestellten Kurzschluss des Solargenerators aufzuheben, wenn z.B. der Fehlerfall nicht mehr vorliegt, und gleichzeitig den Stromfluss zum Wechselrichter wieder herzustellen. Das entspricht einem Ausschaltvorgang in der Kurzschlussstrecke zur Unterbrechung des Kurzschlussstromes und einem Einschaltvorgang in der Trennstrecke. Die Ausführungen sind mit kombinierter Aus-/Einschalt- und Kurzschließ-Funktion (3 Anschlüsse) oder mit voll getrennter Aus-/Einschalt- und Kurzschließ-Funktion (4 getrennte Anschlüsse) möglich. Die Schalteinrichtung ist so im Solargenerator anzuschließen, dass sich die Anschlüsse zum Kurzschließen an der Generatorseite und die Anschlüsse zum Unterbrechen auf der Wechselrichterseite (Leitung zwischen Schalteinrichtung und Wechselrichter) befinden. Jede Ausführung sollte gewährleisten, dass die Auftrennung (Lichtbogenlöschung) sicher vor dem Kurzschließen beendet ist, da sich sonst die Kondensatoren des Wechselrichters mit einem sehr hohen Strom (kurzzeitig bis einige kA) über den Schalter (d.h. den dann vorhandenen Längslichtbogen) entladen können.

Der Strompfad des Kurzschließers kann in der Schalteinrichtung mit einem geeignet ausgelegten Wirkwiderstand versehen werden, um den Kurzschlussstrom zu begrenzen. Der Wirkwiderstand sollte dabei nicht vom Betriebsstrom des Solargenerators durchflossen werden. Vorzugsweise kann dafür der Durchgangsbolzen 15 in Fig. 12 aus einem Werkstoff mit erhöhtem spezifischen elektrischen Widerstand ausgeführt sein. Dadurch wird der transiente elektrische Übergang zum Kurzschluss bedämpft und die Dauerkurzschlussbeanspruchung, insbesondere für die Solarmodule, reduziert. Der Wirkwiderstand muss so dimensioniert sein, dass der Spannungsabfall beim Kurzschlussstrom die zulässigen Werte für den Personenschutz nicht überschreitet.

In Photovoltaik-Anlagen auftretende Impulsströme mit schnellem Stromanstieg werden von der Schalteinrichtung beherrscht, ohne dass es zum Abheben der Kontakte, zu mechanischen Beschädigungen oder zu hohen thermischen Belastungen kommt. Die bevorzugte Ausführung ist so gestaltet, dass nur zwei Unterbrechungsstellen pro Pol vorhanden sind, minimierte innere Stromschleifen vorliegen und entsprechend große Leiterquerschnitte eingesetzt werden. Die Schalteinrichtung kann auch mit mehreren Unterbrechungsstellen pro Pol für den Einsatz bei höheren Systemspannungen ausgeführt sein, wodurch sich aber der Spannungsabfall, die Verluste und die Dauerstromerwärmung erhöhen. Die erwähnten minimalen Stromschleifen werden durch eine möglichst durchgängig geradlinige Leiterführung mit minimaler Kröpfung in der Schalteinrichtung erreicht.

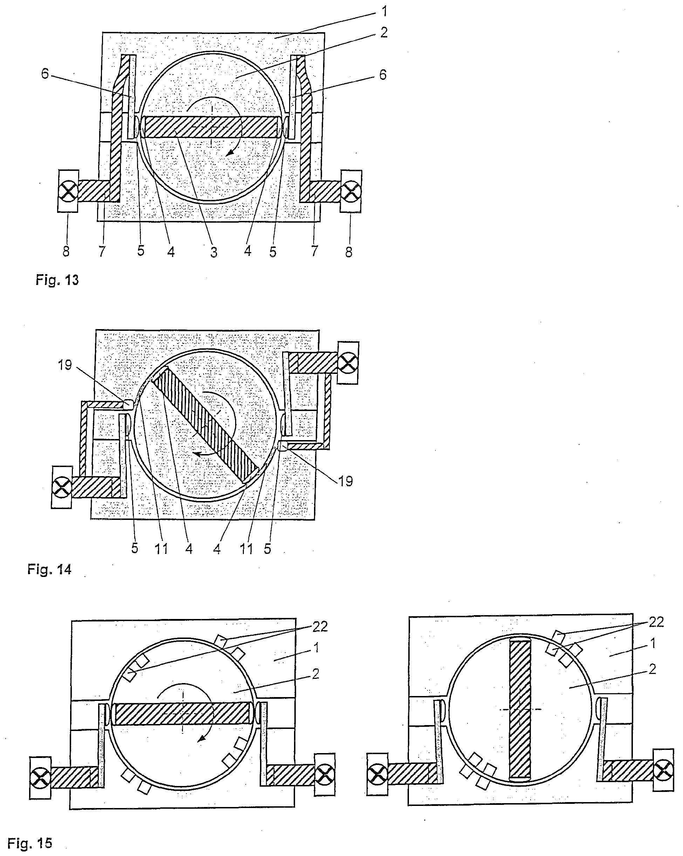

Da im allgemeinen keine aufwendige äußere Verschaltung, z.B. für eine Reihenschaltung von Schaltstrecken, erforderlich ist, entstehen keine äußeren Stromschleifen, welche eine erhöhte Impedanz und Kraftwirkungen bedeuten würden. Andererseits kann die Stromführung in der Schalteinrichtung auch so gestaltet werden (Fig. 13), dass die Stromkräfte, die insbesondere bei großen Impulsströmen wirken, für eine Verstärkung der Kontaktkraft sorgen und entgegen den kontaktabhebenden Kräften gerichtet sind, wodurch eine sehr hohe Impulsstromtragfähigkeit erzielt wird. Die genannten kontaktabhebenden Kräfte entstehen beim Stromfluss über sich punktuell berührende Kontaktstücke entsprechend dem Kraftgesetz nach Lorentz F = I·(l × B) durch entgegengesetzt gerichtete Stromkomponenten in den sich gegenüberstehenden Kontaktstücken. In physikalisch gleicher Weise, jedoch bewusst herbeigeführt, werden in der Anordnung nach Fig. 13 Kräfte durch den entgegengesetzten Stromfluss in der Leiterführung zu den Kontaktstücken erzeugt, welche die sich gegenüberstehenden Kontaktstücke zusammendrücken. Diese Gestaltung der Stromführung bedeutet eine geringfügige Erhöhung der Impedanz, im wesentlichen ergibt sich nur eine größere Induktivität, die wiederum überwiegend bei einer Impulsstrombeanspruchung wirksam wird.

Zur Reduzierung der Lichtbogenwirkung und von Abbranderscheinungen können die aus der Schaltgerätetechnik bekannten Abbrandkontakte eingesetzt werden. Bei einem Ausschaltvorgang trennen sich die Abbrandkontakte nach den Dauerstromkontakten. Damit wird die unmittelbare Lichtbogenbeanspruchung der Dauerstromkontakte vermieden und so der niederohmige Stromübergang im Ein-Zustand dauerhaft gewährleistet. Beim Drehprinzip der Schalteinrichtung können Abbrandkontakte besonders vorteilhaft integriert werden. Die Abbrandkontakte sind dazu so anzuordnen, dass sich der erst bei ihrer Trennung entstehende Ausschaltlichtbogen schon näher am oder bereits tiefer im Isolierstoffspalt befindet und die Lichtbogenlöschung somit beschleunigt wird (Fig. 14).

Hierdurch wird bei kleinen Schaltströmen oder kleinen Schaltspannungen die Entstehung eines Lichtbogens verhindert bzw. der Löschvorgang bereits vor dem Erreichen des thermischen Gleichgewichtes des Lichtbogens eingeleitet, wodurch die beim Ausschaltvorgang umgesetzte Schaltarbeit sehr effizient reduziert wird.

Die Schalteinrichtung kommt prinzipiell ohne die Beschaltung der Schaltstrecke mit aktiven (Halbleiterschaltelemente) oder passiven (ohmsche Widerstände, PTC-Widerstände, Varistoren, Kondensatoren) Löschhilfen aus. Jedoch ist die Nutzung der genannten Beschaltungselemente zusätzlich möglich, um die Lichtbogendauer und die Lichtbogenenergie zu reduzieren. Eine äußere Beschaltung kann somit zur Erhöhung der Schaltleistung oder zur Verringerung des Verschleißes beitragen. Insbesondere sind zusätzliche Hilfskontakte, z.B. die Abbrandkontakte, für den Anschluss von Beschaltungselementen zu verwenden. Um die Trenneigenschaft der Schalteinrichtung zu erhalten, ist die Beschaltung bevorzugt nur über einer Unterbrechungsstelle in der Schalteinrichtung anzuwenden.

Die Ausgestaltung einer Schalteinrichtung mit zwei oder mehr schaltenden Polen in einem Gerät kann für bestimmte Anwendungsfälle vorteilhaft sein. In einem Gleichstromkreis können dann statt der Unterbrechung nur einer Leitung (Plus- oder Minusleitung) bei einpoliger Ausführung gleichzeitig Plus- und Minusleitung bei zweipoliger Ausführung unterbrochen werden.

Außerdem kann bei zwei- oder mehrpoliger Ausführung in Reihenschaltung eine höhere Ausschaltspannung oder in Parallelschaltung ein höherer Dauerstrom beherrscht werden. Wird die Schalteinrichtung z.B. mit Vierfachunterbrechung durch ein angepasstes Kontaktsystem in den durch die Grundanordnung vorgegebenen Isolierstoffteilen ausgeführt, dann bleibt der kompakte Aufbau erhalten. Auch eine Stapelanordnung aus einpoligen Grundanordnungen mit einem Antrieb ist möglich, wobei sich die Bauhöhe vergrößert.

Ist eine Kurzschlussstromerkennung für einen speziellen Einsatzfall erforderlich, dann kann diese als verlustfreie Stromerfassung (Rogowski-Spule, elektro-optisch) ausgeführt werden, die den Antrieb der Schalteinrichtung auslösen kann.

Im Aus-Zustand (geöffnet) muss die Schalteinrichtung bei hoher anliegender Gleichspannung eine sichere Trennstrecke bilden. Durchgehende Gleitstrecken sollten daher vermieden werden. Um dies zu erreichen, können mehrere sich abwechselnde seitlich offene und geschlossene Luftstrecken am Umfang des drehenden Isolierstoffzylinders (Drehzylinder 2) und am Umfang des Loches im Isolierstoffblock (Zylinderaufnahme 1) angebracht werden, die sich erst im Aus-Zustand nach Beendigung der Drehbewegung voll ausbilden (Fig. 15).

Seitlich offen bzw. geschlossen bezieht sich dabei auf die Stirnflächen des Drehzylinders 2 und der Zylinderaufnahme 1. Die offenen Luftstrecken ermöglichen den Austritt gegebenenfalls entstandener Abbrandprodukte (Rußpartikel). Die geschlossenen Luftstrecken sammeln kurzzeitig Isolierstoffgas unter erhöhtem Druck, was eine erhöhte dielektrische Festigkeit bedeutet.

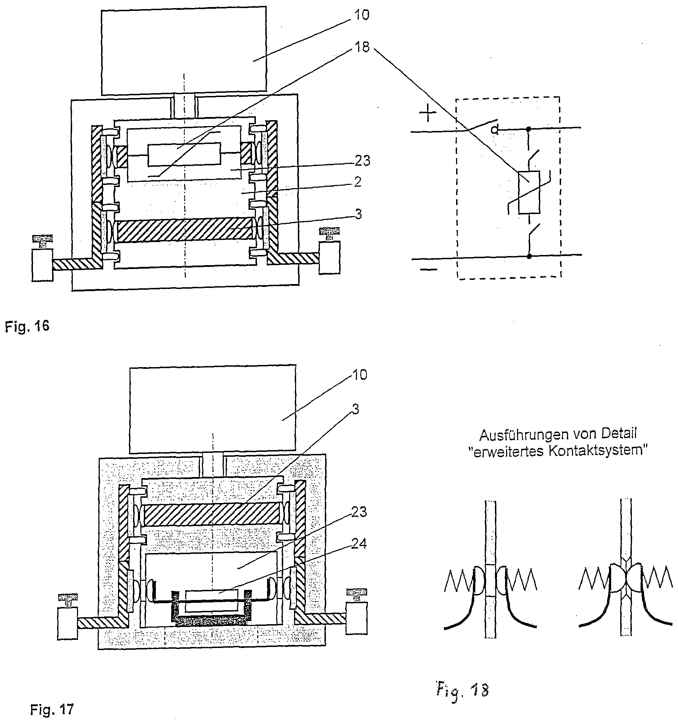

Der Drehzylinder 2 der Schalteinrichtung kann auch als Hohlzylinder ausgeführt werden. Damit ist eine Gewichtsreduktion und eine Verringerung der Antriebskraft der Schalteinrichtung oder eine Vergrößerung der Drehgeschwindigkeit möglich. Andererseits kann ein solcher Hohlraum 23 im Drehzylinder 2 auch zur Aufnahme von Elementen für zusätzliche Funktionen dienen (Fig. 16). Möglich ist hier die Integration eines Überspannungsschutzelementes 18 (Funkenstrecke, Gasableiter, Varistor) oder eines Schaltelementes (Leistungshalbleiter, Schmelzsicherung) im Drehzylinder 2. Das im Drehzylinder 2 zusätzlich eingebrachte Element wird durch die Schaltbewegung (Drehung) je nach Anordnung zu- oder abgeschaltet. Wie in Fig. 16 bzw. Fig. 17 dargestellt, ist es möglich, dass die im Hohlraum 23 vom Drehzylinder 2 eingebrachten Elemente starr mit diesem verbunden sind und sich mitdrehen oder dass die Elemente in der Zylinderaufnahme 1 befestigt sind und sich demzufolge vorteilhaft feststehend in der Schalteinrichtung befinden. Im letzteren Fall macht es sich erforderlich, dass die elektrische Verbindung zu diesen Elementen über ein erweitertes Kontaktsystem (Mitnehmerkontakte), welches zusammen mit dem drehenden Hohlzylinder gebildet wird, herstellbar ist (Fig. 17 links, Fig. 17 rechts). Bei der Nutzung eines Überspannungsschutzelementes ist die vorteilhafte Eigenschaft der Schalteinrichtung, eine hohe Impulsstromtragfähigkeit aufzuweisen, unabdingbar. Mit dem vorgeschlagenen zusätzlichen Schaltelement (Halbleiter, Sicherung) ist eine Reduzierung der Beanspruchung der Schalteinrichtung beim Schalten zu erreichen. Im Ein-Zustand fließt der Strom über das niederohmige Kontaktsystem und den Durchgangsbolzen 3. Der Ausschaltvorgang erfolgt in zeitlicher Folge so, dass der Schaltstrom beim Trennen der Schaltkontakte ohne Lichtbogen auf das parallele Schaltelement (Leistungshalbleiter, Schmelzsicherung 24) kommutiert, welches den Strom unterbricht.

Dabei soll das zusätzliche Schaltelement nur an einer Unterbrechungsstelle in der Schalteinrichtung eingesetzt werden, die andere in Reihe liegende Unterbrechungsstelle dient dem Herstellen der Trennstrecke. Bei Verwendung einer Schmelzsicherung muss diese nach dem Abschalten ersetzt werden. Ein geschaffener Hohlraum 23 kann auch die Einrichtungen zur Detektion des Abbrandzustandes und zur Blockierung des Schaltmechanismus aufnehmen, wodurch sich eine Raumeinsparung für die gesamte Schalteinrichtung ergibt.

Die erfindungsgemäße Schalteinrichtung und das durch sie realisierte Verfahren greift auf das Prinzip der Trennung von Kontakten zurück, wobei mindestens einer der Kontakte beweglich ausgeführt ist derart, dass der Lichtbogen in einem engen Spalt aus gasabgebendem Material entsteht bzw. dort hinein verbracht wird. Die vorgeschlagene geometrische Anordnung stellt sicher, dass während der Bewegung mindestens ein durchschnittlicher Spannungsanstieg von 300 V/ms über einen Zeitraum von höchstens 4 ms erreichbar ist.

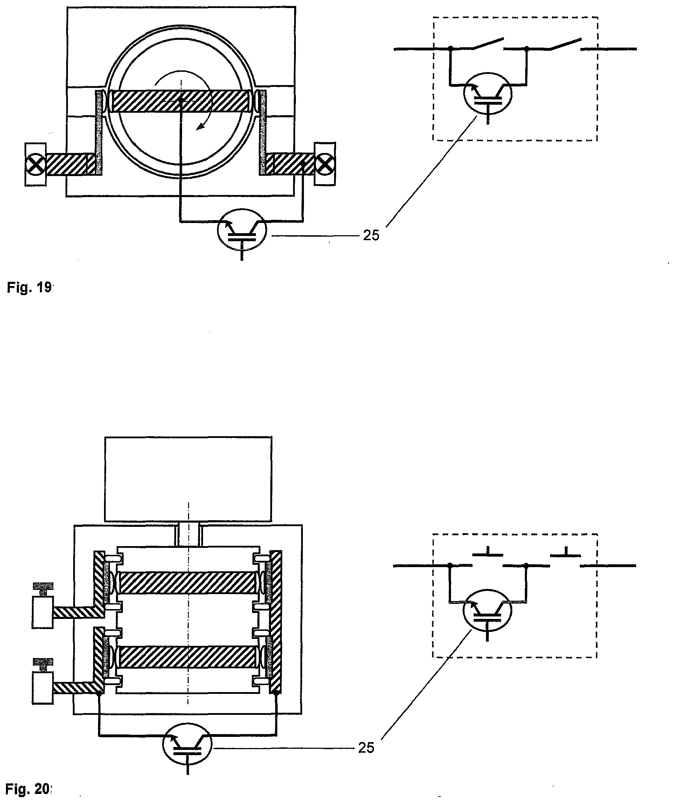

Mit den Ausführungsformen gemäß den Fig. 19 bis 25 sind Lösungsansätze zur Ertüchtigung des Schalters zum Erreichen einer erhöhten Schaltspielanzahl gezeigt, wobei es hier gilt, einen vollfertigen Trennschalter für Betriebsfunktionen zu schaffen. Grundsätzlich wird gemäß diesem Lösungsansatz eine Kombination eines Spaltschalters mit elektronischen Löschhilfen im Sinne eines Hybridschalters vorgenommen. Gemäß Fig. 19 wird eine Schalteinrichtung gezeigt, bei welcher ein Halbleiterschalter 25 zur Reduzierung der Beanspruchung der Schalteinrichtung parallel geschaltet wird. Hier ist der Halbleiterschalter 25 nur an eine der beiden Unterbrechungsstellen der Schalteinrichtung angeschlossen, so dass die galvanische Trennung durch die Schalteinrichtung erhalten bleibt, wie vorausstehend geschildert wurde.

Der Anschluss des Halbleiterschalters 25 erfolgt gemäß Fig. 19 über einen Hauptanschluss der Schalteinrichtung 8 sowie über einen zusätzlichen Hilfsanschluss am beweglichen Bolzen 3. Da der Halbleiterschalter 25 nur kurzzeitig stromführend ist, kann der Hilfsanschluss mit einem relativ geringen Anschlussquerschnitt versehen sein, wodurch sich vielfältige Möglichkeiten im Sinne einer einfachen konstruktiven Ausführung ergeben.

Beim Öffnen der Schalteinrichtung wird der Halbleiterschalter 25 angesteuert. In der parallelen Schaltstrecke wird ein Lichtbogen verhindert oder gelöscht. Dadurch wird die Schaltstrecke kaum belastet. Nach einer minimalen Schließzeit des Halbleiterschalters von weniger als einigen Millisekunden unterbricht der Halbleiter den Strom. Der Lichtbogen im Schaltkontakt ohne parallelen Halbleiterschalter verlischt ebenfalls, womit der Schaltvorgang beendet ist.

Der elektrisch und magnetisch gesteuerte Schaltvorgang wird dabei so ausgelegt, dass die Belastung des Schaltkontakts ohne parallelen Halbleiterschalter deutlich unterhalb seines Schaltvermögens liegt. Durch eine derartige Schalteinrichtung kann die Lebensdauer und die Anzahl der elektrischen Schaltspiele gegenüber einer Ausführungsform ohne elektronische Unterstützung deutlich erhöht werden. Im Vergleich zu konventionellen Hybridschaltern besteht der Vorteil, dass der erfindungsgemäße Schalter auch bei Ausfall der elektronischen Steuerung mehrfach erfolgreich den Stromkreis unterbrechen kann.

Fig. 20 zeigt eine Prinzipdarstellung einer Ausführungsform ohne Kontaktierung des bewegten Kontaktbolzens 3 analog zur Gestaltungsvariante mit zweipoliger Schalteinrichtung, wie anhand der Fig. 12 und 17 erläutert.

Bei Photovoltaik-Anlagen ist es häufig üblich, beide Phasen, also die Plus- und die Minusleitung zu unterbrechen. Ebenso kann es sinnvoll sein, nach der Unterbrechung der Phasen und der Abtrennung des Wechselrichters (siehe Fig. 9) den Photovoltaik-Generator kurz zu schließen.

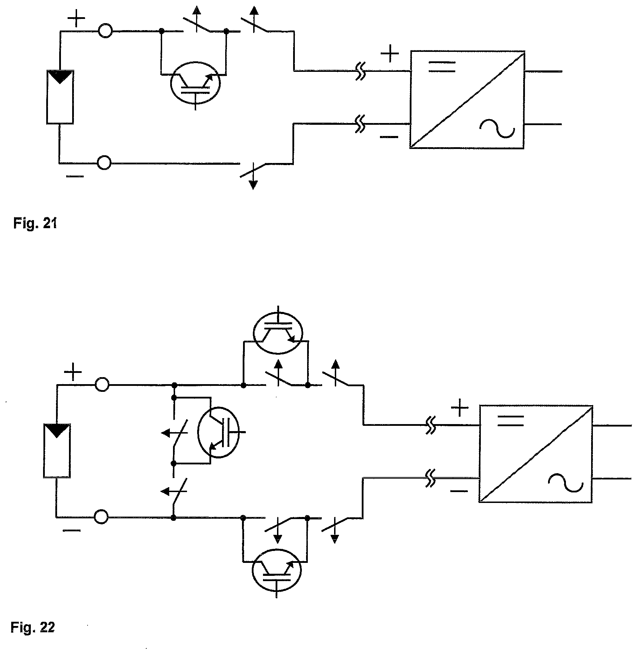

Eine derartige stufenweise Realisierung des Schutzes kann selbstverständlich durch separat aufgebaute Schalteinrichtungen mit Hybridschalter und gegebenenfalls mit mechanisch gekoppelten Auslösern für die Unterbrechung des Plus- und Minuspols realisiert werden, wie in der Fig. 22 als Blockschaltbild gezeigt.

Eine solche anwendungsrelevante Lösung kann auch in einer Schalteinrichtung mit mehreren schaltenden Polen realisiert werden.

Hierbei würde die Anordnung gemäß Fig. 12 mit einer weiteren Etage ergänzt werden, wodurch nur ein Antrieb nötig ist.

Jede der Schalteinrichtungen der dann drei Etagen könnte entsprechend Fig. 19 mit einem Kontakt als Hybridschalter versehen sein. Die Kontaktbolzen 3 der Etage der Plus- und der Minusphase liegen dann in einer Achse und öffnen somit gleichzeitig, während der Kontaktbolzen 3 des Kurzschließers versetzt angeordnet ist und hierdurch zeitlich versetzt schließt.

Das Schließen des Kurzschließers erfolgt zeitlich nach der Abschaltung durch den Hybridschalter. Der Hybridschalter des Kurzschließers gemäß Fig. 22 ist für die Wiederinbetriebnahme der Anlage, also das Öffnen des Kurzschließers sinnvoll.

In diesem Fall muss der Kurzschließer den Kurzschlussstrom der Photovoltaik-Anlage gegen die Leerlaufspannung der Anlage abschalten, bevor die Schalter in den Phasen (längs) die Verbindung zu den Wechselrichtern realisieren.

In Anlagen, bei welchen die Speicherkapazität des Wechselrichters nach Unterbrechung der Phasen entladen wird, kann die Verbindung der Phasen auch früher erfolgen. Bei der Öffnung des Kurzschließers wirkt die zu entladende Kapazität quasi als Löschhilfe für den Kurzschließerschalter.

Die Fig. 21 zeigt eine vereinfachte Anordnung ohne Kurzschließer und mit nur einem Hybridschalter in einer Phase. Die weitere Phase besitzt hier nur einen Trennschalter. Dieser Aufbau lässt sich mit einer Schalteinrichtung mit zwei Ebenen gemäß Fig. 12 realisieren, wobei eine Ebene einen Hybridschalter gemäß Fig. 19 beinhaltet.

Bei einer anlagenspezifischen komplexen Anordnung, z.B. entsprechend dem Blockschaltbild nach Fig. 22, beispielsweise mit Einzelschaltern gemäß Fig. 19 oder auch Schaltern mit mehreren Etagen und einem gemeinsamen Antrieb (z.B. Fig. 12) kann es sinnvoll sein, die Funktion des Halbleiterschalters für mehrere Schaltstrecken gemeinsam zu nutzen, wodurch die Anzahl der recht kostenintensiven Leistungshalbleiter reduziert werden kann.

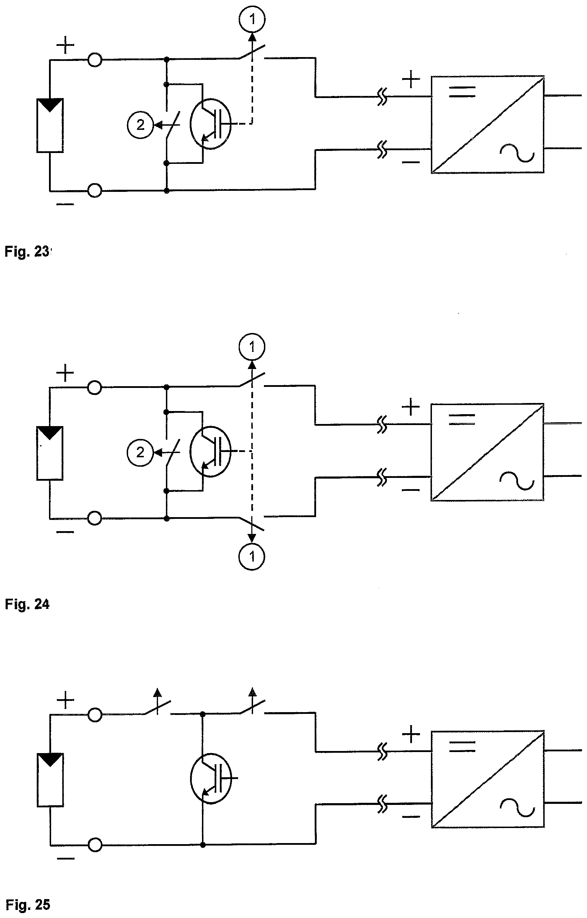

Die Fig. 23 zeigt eine Anordnung eines Kurzschließers 2 und eines Schalters 1 in der Plus-Leitung, wobei deren Löschvorgang nur durch einen gemeinsamen Halbleiterschalter unterstützt wird. Die Ausführung ist beispielsweise für Anlagen mit Maßnahmen gegen Rückströme aus den Speicherkapazitäten geeignet. Prinzipiell kann eine solche Anordnung jedoch auch dort eingesetzt werden, wo der Einbauort bzw. die vorhandenen Impedanzen keine nennenswerten Rückströme erlauben.

Ein solcher Einsatz ist jedoch auch dann möglich, wenn die Impedanz im Kreis des Halbleiterschalters, des Kurzschließers bzw. auch die Impedanz des Schaltlichtbogens des Schalters 1 einen so hohen Wert besitzen, dass keine erhöhten Rückströme möglich sein.

Neben der Einbindung von zusätzlichen Impedanzen außerhalb der Phasen, also im Querzweig mit Kurzschließer und Halbleiterschalter, kann der Halbleiterschalter auch erst bei Erreichen einer z.B. über die Spannung definierten Impedanz des Schaltlichtbogens im Schalter 1 aktiviert werden, wodurch eine Überlastung des Halbleiterschalters sicher vermieden wird. Der Schalter 1 wird trotz der benötigten erhöhten Lichtbogenspannung noch ausreichend entlastet, da aufgrund der Kennlinie der Photovoltaik-Quelle der größte Anteil der Schaltleistung erst bei einer Spannung im Bereich der Nennspannung bis zur Abschaltung umgesetzt wird.

Die Fig. 24 zeigt eine entsprechende Anordnung mit Unterbrechung in beiden Phasen, d.h. in der Plus- und Minusleitung.

Nachteilig für eine Photovoltaik-Anlage wäre bei den Anordnungen nach den Fig. 23 und 24 mit Halbleiterschalter im Querzweig die Tatsache, dass der ausgeschaltete Halbleiterschalter bei Verzicht auf eine weitere serielle Trennstrecke im Querzweig für den normalen Betrieb nicht galvanisch abgetrennt ist. Neben der zusätzlichen Trennstrecke im Querzweig, z.B. entsprechend Fig. 22, ist auch eine Anordnung des Halbleiterschalters gemäß Fig. 25 möglich. Eine solche einfache Lösung kann selbstverständlich auch auf komplexere Anordnungen je nach jeweiliger Anlagenkonfiguration übertragen werden.

### Bezugszeichenliste

- 1: Zylinderaufnahme
- 2: Drehzylinder
- 3: Durchgangsbolzen, Kontaktbolzen
- 4: mitdrehendes Kontaktstück (innen)
- 5: festes Kontaktstück (außen); Gegenkontaktstück
- 6: Federelement
- 7: Anschlussstück
- 8: Anschlussklemme
- 9: Abhebeelement
- 10: Drehantrieb
- 11: Ausschaltlichtbogen
- 12: gemeinsame "Plus"-Klemme an Solargenerator und für Kurzschluss
- 13: "Plus"-Klemme in Leitung zum Wechselrichter
- 14: "Minus"-Klemme für Kurzschluss
- 15: mitdrehendes Kontaktstück (innen) und Durchgangsbolzen für Kurzschluss
- 16: festes Kontaktstück (außen) für Kurzschluss
- 17: Ansatzfläche
- 18: Überspannungsschutzelement
- 19: Abbrandkontakt
- 20: Blockier- bzw. Verrastelement
- 21: Anzeige der Blockierung
- 22: offene und geschlossene Luftstrecken
- 23: Hohlraum in Drehzylinder
- 24: Sicherung (Schmelzsicherung) feststehend
- 25: Halbleiterschalter

## Patentansprüche

1. Ein- oder mehrpolige Schalteinrichtung für Gleichstromanwendungen in Photovoltaikanlagen, mit mindestens einem rotierenden Schaltelement, welches mit einem Antrieb in Verbindung steht, sowie umfassend Schaltkontakte, Anschlussstücke und Anschlusspole oder Anschlussklemmen und eine die vorgenannten Teile aufnehmende Gehäuseanordnung, wobei in der Gehäuseanordnung ein beweglich geführter Drehzylinder (2) ausgebildet ist, der sich in einem als Drehzylinderaufnahme (1) ausgeführten Körper befindet,
der Drehzylinder (2) mindestens einen, den Drehzylinder (2) durchdringenden Kontaktbolzen (3) aufweist, der an seinem Ende jeweils ein Kontaktstück (4) besitzt,
wobei die Länge des Kontaktbolzens (3) einschließlich der an ihm befindlichen oder dort ausgebildeten Kontaktstücke (4) kleiner oder gleich dem Außendurchmesser des Drehzylinders (2) ist,
in der Drehzylinderaufnahme (1) Gegenkontaktstücke (5) angeordnet sind, welche mit den Anschlussstücken (7) oder Anschlusspolen bzw. Anschlussklemmen (8) in elektrischer Verbindung stehen,
zwischen dem Drehzylinder (2) und der Drehzylinderaufnahme (1) ein enger, lichtbogenbeeinflussender Spalt besteht, wobei infolge der Bewegung des Drehzylinders (2) mit Kontaktbolzen (3) die elektrische Verbindung zwischen den Kontaktstücken (4) und den Gegenkontaktstücken (5) aufhebbar ist und die entstehenden Ausschaltlichtbögen einer Verlängerung unterliegend in den Luftspalt eindringen und dort schnell gelöscht werden, **dadurch gekennzeichnet, dass** der enge, lichtbogenbeeinflussende Spalt eine Spaltbreite von kleiner 200 µm aufweist, und dass zwischen Drehzylinder (2) und Drehzylinderaufnahme (1) ein Blockierelement (20) vorgesehen ist, welches sich in einer Führung befindet, deren Öffnung dann freigegeben wird, wenn ein Verschleiß des die Öffnung verschließenden Materials eintritt, wobei das Blockierelement (20) dann in eine komplementäre Ausnehmung eingreift, um erneute Schaltvorgänge zu unterbinden.

2. Schalteinrichtung nach Anspruch 1,
**dadurch gekennzeichnet, dass**
mindestens Teile oder Oberflächenabschnitte des Drehzylinders (2) und/oder der Drehzylinderaufnahme (1) an ihren zum Luftspalt weisenden Bereichen aus einem Löschgas abgebenden Material, insbesondere POM bestehen.

3. Schalteinrichtung nach einem der vorangegangenen Ansprüche,
**dadurch gekennzeichnet, dass**
die Gegenkontaktstücke (5) mit einer mechanischen Vorspannung in Richtung des Drehzylinders beaufschlagt sind.

4. Schalteinrichtung nach einem der vorangegangenen Ansprüche,
**dadurch gekennzeichnet, dass**
im Bereich der Gegenkontaktstücke (5) mindestens ein Tast- oder Abhebeelement (9) vorgesehen ist, welches an der Außenoberfläche des Drehzylinders (2) anliegt und bei einer Drehbewegung in Öffnungsrichtung der Schalteinrichtung die Gegenkontaktstücke (5) abhebt, wobei in Schließstellung der Schalteinrichtung das oder die Tastelemente in eine entsprechende Ausnehmung im Drehzylinder eintauchen.

5. Schalteinrichtung nach einem der vorangegangenen Ansprüche,
**dadurch gekennzeichnet, dass**
die zueinander weisenden Seiten der Kontakt- und Gegenkontaktstücke (4; 5) eine Halbkugel-, Pilzkopf- oder ähnliche abgerundete Form besitzen.

6. Schalteinrichtung nach einem der vorangegangenen Ansprüche,
**dadurch gekennzeichnet, dass**
in einer Einebenen- oder Zweiebenen-Anordnung nach einem Öffnungsvorgang der Schalteinrichtung mit Hilfe des ersten oder eines zweiten Kontaktbolzens eine Kurzschließfunktion ausgelöst wird, wobei hierfür in der Drehzylinderaufnahme (1) weitere Gegenkontaktstücke (5) angeordnet sind, die mit weiteren Anschlussstücken (7) oder Anschlusspolen bzw. Anschlussklemmen (8) in elektrischer Verbindung stehen.

7. Schalteinrichtung nach Anspruch 6,
**dadurch gekennzeichnet, dass**
in einer ersten Ebene im Drehzylinder (2) der Kontaktbolzen für das Öffnen und Schließen und in einer zweiten Ebene im Drehzylinder (2) der
Kontaktbolzen (15) für das Kurzschließen befindlich ist, wobei die Kontaktbolzen in einem Winkel zueinander versetzt angeordnet sind.

8. Schalteinrichtung nach Anspruch 6 oder 7,
**dadurch gekennzeichnet, dass**
der Kurzschließ-Kontaktbolzen (15) einen Wirkwiderstand aufweist.

9. Schalteinrichtung nach einem der vorangegangenen Ansprüche,
**dadurch gekennzeichnet, dass**
den Gegenkontakt- (5) und/oder den Kontaktstücken (4) benachbarte Abbrandkontakte vorgesehen sind.

10. Schalteinrichtung nach einem der vorangegangenen Ansprüche, **dadurch gekennzeichnet, dass**
die Stromführung zu den Gegenkontaktstücken (5) über die Anschlussstücke unter Nutzung der Lorentz-Kraft bei fließenden Impulsströmen ausgeführt ist, so dass eine Verstärkung der Kontaktkraft zwischen Kontaktstück und Gegenkontaktstück gegeben ist.

11. Schalteinrichtung nach einem der vorangegangenen Ansprüche,
**dadurch gekennzeichnet, dass**
in den zueinander weisenden Oberflächen von Drehzylinder (2) und Drehzylinderaufnahme (1) Kriechstrecken vergrößerende Rücksprünge oder Ausnehmungen vorgesehen sind, welche je nach Drehlageposition offene oder geschlossene Luftstrecken bilden.

12. Schalteinrichtung nach einem der vorangegangenen Ansprüche,
**dadurch gekennzeichnet, dass**
der Drehzylinder (2) Hohlräume zur Aufnahme von zusätzlichen Bauelementen (18) wie Sicherungen (24), Überspannungsschutzelemente oder Halbleiter aufweist.

13. Schalteinrichtung nach Anspruch 12,
**dadurch gekennzeichnet, dass**
zum elektrischen Anschluss der in dem oder den Hohlräumen befindlichen Bauelemente zusätzliche Kontaktstücke und Gegenkontaktstücke vorhanden sind.

14. Kontaktanordnung, einer Schalteinrichtung nach einem oder mehreren der vorangegangenen Ansprüche,
**dadurch gekennzeichnet, dass**
diese ein Paar drehbeweglicher Kontaktstücke sowie ein Paar feststehender Gegenkontaktstücke aufweist, wobei die zueinander weisenden Oberflächen der Kontakt- und Gegenkontaktstücke eine Halbkugel, Pilzkopf- oder dergleichen abgerundete Form besitzen und bei einer Relativbewegung durch Verschwenken oder Verdrehen die sich zentral berührenden Oberflächenabschnitte außer Kontakt treten und sich zwischen den voneinander entfernenden Rändern jeweils ein Lichtbogen bildet, welcher in einem Ringspalt entsteht bzw. in diesen gezogen wird, der geometrie- und bewegungsbedingt zwischen Kontakt- und Gegenkontaktstück jeweils besteht.

## Claims

1. Single- or multi-pole switching device, in particular for direct current applications in photovoltaic systems, comprising at least one rotating switching element which is connected to a drive, and also comprising switching contacts, connection pieces and connection poles or connection terminals as well as a housing arrangement receiving the aforementioned parts,
wherein
a movably guided rotary cylinder (2) is formed in the housing arrangement, which is located in a body designed as a rotary cylinder receptacle (1),
the rotary cylinder (2) comprises at least one contact pin (3) which passes through the rotary cylinder (2) and has a contact piece (4) at each end, wherein the length of the contact pin (3) including the contact pieces (4) located or formed there is smaller than or equal to the outer diameter of the rotary cylinder (2),
mating contact pieces (5) are arranged in the rotary cylinder receptacle (1), which are electrically connected to the connection pieces (7) or connection poles, respectively connection terminals (8),
a narrow, arc-influencing gap is present between the rotary cylinder (2) and the rotary cylinder receptacle (1), wherein as a consequence of the motion of the rotary cylinder (2) with the contact pin (3) the electrical connection between the contact pieces (4) and the mating contact pieces (5) can be cancelled and the formed break arcs, subject to an extension, penetrate into the air gap and are rapidly extinguished there, **characterized in that** the narrow, arc-influencing gap has a gap width of less than 200 mm, and that a blocking element (20) is provided between the rotary cylinder (2) and the rotary cylinder receptacle (1), which is located in a guide whose opening is cleared when the material sealing the opening begins to wear, wherein the blocking element (20) then engages with a complementary recess so as to suppress new switching operations.

2. Switching device according to claim 1,
**characterized in that**
at least parts or surface sections of the rotary cylinder (2) and/or the rotary cylinder receptacle (1) are made, in their areas pointing to the air gap, of a material emitting an extinction gas, in particular POM.

3. Switching device according to one of the preceding claims,
**characterized in that**
the mating contact pieces (5) are subjected to a mechanical preload in the direction of the rotary cylinder.

4. Switching device according to one of the preceding claims,
**characterized in that**
at least one tracing element or lift-off element (9) is provided in the area of the mating contact pieces (5), which bears against the outer surface of the rotary cylinder (2) and lifts off the mating contact pieces (5) upon a rotary motion in the opening direction of the switching device, wherein the tracing element(s) immerse(s) into a corresponding recess in the rotary cylinder in the closed position of the switching device.

5. Switching device according to one of the preceding claims,
**characterized in that**
the sides of the contact pieces and mating contact pieces (4; 5) pointing to each other have the shape of a hemisphere, a mushroom head or a similar rounded shape.

6. Switching device according to one of the preceding claims,
**characterized in that**
in a one-level or a two-level arrangement, after an opening operation of the switching device by means of the first or a second contact pin, a short-circuit function is released, wherein, to this end, additional mating contact pieces (5) are arranged in the rotary cylinder receptacle (1) which are electrically connected to additional connection pieces (7) or connection poles, respectively connection terminals (8).

7. Switching device according to claim 6,
**characterized in that**
the contact pin for the opening and closing is located in the rotary cylinder (2) in a first level and the contact pin (15) for the short-circuiting is located in the rotary cylinder (2) in a second level, wherein the contact pins are arranged offset relative to each other at an angle.

8. Switching device according to claim 6 or 7,
**characterized in that**
the short-circuit contact pin (15) has an active resistance.

9. Switching device according to one of the preceding claims,
**characterized in that**
burn-off contacts adjacent to the mating contact pieces (5) and/or the contact pieces (4) are provided.

10. Switching device according to one of the preceding claims,
**characterized in that**
the current supply to the mating contact pieces (5) is accomplished through the connection pieces, using the Lorentz force in pulsed current flows such that the contact force between the contact piece and the mating contact piece is increased.

11. Switching device according to one of the preceding claims,
**characterized in that**
offsets or recesses are provided in the surfaces of the rotary cylinder (2) and the rotary cylinder receptacle (1) pointing to each other, which increase the creepage distances and, depending on the rotational position, define open or closed air gaps.

12. Switching device according to one of the preceding claims,
**characterized in that**
the rotary cylinder (2) comprises cavities for receiving additional components (18), such as fuses (24), overvoltage protection elements or semiconductors.

13. Switching device according to claim 12,
**characterized in that**
additional contact pieces and mating contact pieces are provided to electrically connect the components located inside the cavities.

14. Contact arrangement of a switching device according to one or more of the preceding claims,
**characterized in that**
same comprises a pair of rotationally movable contact pieces and a pair of stationary mating contact pieces, wherein the surfaces of the contact pieces and mating contact pieces pointing to each other have the shape of a hemisphere, a mushroom head or a similar rounded shape, and upon a relative motion by pivoting or rotating the surface sections which touch each other centrally lose contact and an arc is formed between the edges moving apart from each other, which is formed in or drawn into an annular gap that is produced by geometry and motion between the contact piece and the mating contact piece.

## Revendications

1. Dispositif de commutation unipolaire ou multipolaire pour application en courant continu dans des installations photovoltaïques, comprenant au moins un élément commutateur rotatif, qui est en liaison avec un entraînement, et comprenant des contacts de commutation, des pièces de connexion et des pôles de connexion ou des bornes de connexion, et un agencement formant boîtier qui reçoit les pièces précitées,
dans lequel, dans l'agencement formant boîtier, il est réalisé un cylindre rotatif (2) qui est guidé en déplacement, et qui se trouve dans un corps réalisé sous forme de logement (1) pour cylindre rotatif,
le cylindre rotatif comprend au moins un goujon de contact (3) qui traverse le cylindre rotatif (2) et qui possède à son extrémité une pièce de contact respective (4),
dans lequel la longueur du goujon de contact (3), y compris des pièces de contact (4) qui se trouvent sur lui-même ou qui y sont réalisées, est inférieure ou égale au diamètre extérieur du cylindre rotatif (2),
dans le logement (1) pour cylindre rotatif sont agencées des pièces de contact antagonistes (5) qui sont en liaison électrique avec les pièces de connexion (7) ou les pôles de connexion ou les bornes de connexion (8),
entre le cylindre rotatif (2) et le logement (1) pour cylindre rotatif il existe une fente étroite capable d'influencer un arc électrique,
dans lequel suite au mouvement du cylindre rotatif (2) avec les goujons de contact (3) la liaison électrique entre les pièces de contact (4) et les pièces de contact antagonistes (5) peut être annulé et les arcs électriques de coupure qui se produisent pénètre dans la fente d'air en subissant un prolongement et y sont rapidement éteints, **caractérisé en ce que** la fente étroite capable d'influencer un arc électrique présente une largeur de fente inférieure à 200 µm, et
**en ce qu'**il est prévu, entre le cylindre rotatif (2) et le logement (1) pour cylindre rotatif, un élément de blocage (20) qui se trouve dans un guidage dont l'ouverture est libérée lorsqu'il se produit une usure du matériau qui obture l'ouverture, et élément de blocage (20) s'engage alors dans un évidement complémentaire afin d'interdire de nouveaux processus de commutation.

2. Dispositif de commutation selon la revendication 1,
**caractérisé en ce qu'**au moins des parties ou des portions de surface du cylindre rotatif (2) et/ou du logement (1) pour cylindre rotatif sont constituées, au niveau de leurs régions tournées vers la fente d'air, en un matériau qui dégage un gaz d'extinction, en particulier du POM.

3. Dispositif de commutation selon l'une des revendications précédentes,
**caractérisé en ce que** les pièces de contact antagonistes (5) sont sollicitées par une précontrainte mécanique en direction du cylindre rotatif.

4. Dispositif de commutation selon l'une des revendications précédentes,
**caractérisé en ce que**
dans la zone des pièces de contact antagonistes (5) il est prévu au moins un élément en forme de touche ou un élément de soulèvement (9), qui s'applique contre la surface extérieure du cylindre rotatif (2) et qui, lors d'un mouvement de rotation en direction d'ouverture du dispositif de commutation, soulève les pièces de contact antagonistes (5) et, en position de fermeture du dispositif de commutation, l'élément ou les éléments en forme de touche plonge(nt) dans un évidement correspondant dans le cylindre rotatif.

5. Dispositif de commutation selon l'une des revendications précédentes,
**caractérisé en ce que** les côtés en vis-à-vis des pièces de contact et des pièces de contact antagonistes (4 ; 5) possèdent une forme hémisphérique, une forme en tête de champignon, ou une forme arrondie similaire.

6. Dispositif de commutation selon l'une des revendications précédentes,
**caractérisé en ce que**
dans un agencement sur un seul plan ou dans un agencement sur deux plans, après un processus d'ouverture du dispositif de commutation avec l'aide du premier goujon de contact ou d'un second goujon de contact, une fonction de court-circuit est déclenchée, et à cet effet d'autres pièces de contact antagonistes (5) sont agencées dans le logement (1) pour cylindre rotatif, pièces qui sont en liaison électrique avec d'autres pièces de connexion (7) ou pôles de connexion ou bornes de connexion (8).

7. Dispositif de commutation selon la revendication 6,
**caractérisé en ce que** le goujon de contact pour l'ouverture et la fermeture se trouve dans un premier plan dans le cylindre rotatif (2) et le goujon de contact (15) pour la mise en court-circuit se trouve dans un second plan dans le cylindre rotatif (2), et les goujons de contact sont agencés de façon décalée l'un par rapport à l'autre sous un angle.

8. Dispositif de commutation selon la revendication 6 ou 7,
**caractérisé en ce que** le goujon de contact (15) de court-circuit présente une résistance efficace.

9. Dispositif de commutation selon l'une des revendications précédentes, **caractérisé en ce qu'**il est prévu des contacts consommables au voisinage des pièces de contact (4) et/ou des pièces de contact antagonistes (5).

10. Dispositif de commutation selon l'une des revendications précédentes,
**caractérisé en ce que** l'amenée de courant aux pièces de contact antagonistes (5) est assurée via les pièces de connexion en exploitant la force de Lorenz avec des courants qui s'écoulent par impulsions, de sorte qu'il se produit une amplification de la force de contact entre la pièce de contact et la pièce de contact antagoniste.

11. Dispositif de commutation selon l'une des revendications précédentes,
**caractérisé en ce que**, dans les surfaces en vis-à-vis du cylindre rotatif (2) et du logement (1) pour cylindre rotatif, il est prévu des ressauts ou des évidements qui augmentent les lignes de fuite et qui, selon la position en rotation, forment des intervalles ouverts ou fermés.

12. Dispositif de commutation selon l'une des revendications précédentes,
**caractérisé en ce que** le cylindre rotatif (2) présente des cavités pour la réception d'éléments structurels additionnels (18) tels que des fusibles (24), des éléments de protection antisurtension ou des semiconducteurs.

13. Dispositif de commutation selon la revendication 12,
**caractérisé en ce qu'**il est prévu des pièces de contact et des pièces de contacts antagonistes supplémentaires pour la connexion électrique des éléments structurels qui se trouvent dans la cavité ou dans les cavités.

14. Agencement de contact d'un dispositif de commutation selon l'une ou plusieurs des revendications précédentes,
**caractérisé en ce que** celui-ci comprend une paire de pièces de contact mobiles en rotation ainsi qu'une paire de pièces de contact antagonistes stationnaires, et les surfaces en vis-à-vis des pièces de contact et des pièces de contact antagonistes possèdent une forme hémisphérique, en champignon ou une forme arrondie similaire et, lors d'un mouvement relatif par pivotement ou par rotation, les portions de surfaces centrales qui se touchent sont mises hors contact et entre les bordures qui s'éloignent l'une de l'autre il se forme respectivement un arc électrique, lequel apparaît dans une fente annulaire et est tiré dans celle-ci, ladite fente apparaissant respectivement entre la pièce de contact et la pièce de contact antagoniste à cause de la géométrie et des déplacements.
